# EUROPEAN PATENT APPLICATION

(11) **EP 4 527 803 A1**
(43) Date of publication of application: **26.03.2025**
(21) Application number: 24191542.0
(22) Date of filing: 29.07.2024
(51) Int. Cl.: C01G 45/12, C01G 53/00, H01M 4/131, H01M 4/505, H01M 4/525, C01G 45/1221

(54) **POSITIVE ELECTRODE ACTIVE MATERIAL, POSITIVE ELECTRODE, AND RECHARGEABLE LITHIUM BATTERIES**

(30) Priority: 03.08.2023 KR 20230101768
(71) Applicant: SAMSUNG SDI CO., LTD., Giheung-gu Yongin-si, Gyeonggi-do 17084 (KR)
(72) Inventor: KIM, Young-Ki, Yongin-si 17084 (KR); CHOO, Sung Ho, 17084 Yongin-si (KR); JUN, Dowook, 17084 Yongin-si (KR); KANG, Gwiwoon, 17084 Yongin-si (KR); JEONG, Jaeyong, 17084 Yongin-si (KR); KONG, Youngsun, 17084 Yongin-si (KR); KANG, Byungwuk, 17084 Yongin-si (KR); YOON, Jaesang, 17084 Yongin-si (KR); DOO, Sungwook, 17084 Yongin-si (KR); KANG, Seok Mun, 17084 Yongin-si (KR)
(74) Representative: Marks & Clerk LLP

(57) **Abstract**

A positive electrode active material includes a first positive electrode active material that includes a lithium nickel-manganese-based composite oxide having a nickel content of greater than or equal to about 60 mol% based on 100 mol% of a total metal excluding lithium in the first positive electrode active material and is in a form of secondary particles in which a plurality of primary particles are agglomerated, a second positive electrode active material in a form of single particles including a lithium nickel-manganese-based composite oxide having a nickel content of greater than or equal to about 60 mol% based on 100 mol% of a total metal excluding lithium in the second positive electrode active material, and a third positive electrode active material in a form of particles including lithium manganese-based oxide. In addition, a positive electrode and a rechargeable lithium battery each including the positive electrode active material are disclosed.

## Description

### BACKGROUND

### 1. Field

One or more embodiments of the present disclosure relate to positive electrode active materials, and positive electrodes and rechargeable lithium batteries each including the positive electrode active materials.

### 2. Description of Related Art

A portable information device such as a cell phone, a laptop, smart phone, and/or the like or an electric vehicle has utilized a rechargeable lithium battery having relatively high energy density and relatively easy portability as a driving power source. Recently, research has been actively conducted to utilize a rechargeable lithium battery with relatively high energy density as a driving power source for hybrid or electric vehicles (automotive battery) or as a power storage power source for energy storage systems or power walls (ESS).

Various positive electrode active materials have been investigated to realize rechargeable lithium batteries for such desired applications. Among them, lithium nickel-based oxide, lithium nickel manganese cobalt composite oxide, lithium nickel cobalt aluminium composite oxide, and lithium cobalt oxide are mainly utilized as positive electrode active materials. However, while a demand and utilization for large-sized, relatively high-capacity, or relatively high-energy density rechargeable lithium batteries has recently increased rapidly, a supply of positive electrode active materials including cobalt, which is a rare metal, is expected to be in severely short supply. For example, because cobalt is expensive and has limited remaining reserves, there is a need and/or desire to develop a positive electrode active material excluding the cobalt or including it in a reduced content (e.g., amount).

### SUMMARY

One or more aspects of embodiments of the present disclosure are directed toward a positive electrode active material including a lithium nickel-manganese-based composite oxide, which reduces the price of the positive electrode material, secures high capacity and high energy density characteristics, and improves high-voltage performance by suppressing or reducing a side reaction with an electrolyte at a relatively high voltage, and a positive electrode and a rechargeable lithium battery, each of which includes the positive electrode active material. Additional aspects will be set forth in part in the description which follows and, in part, will be apparent from the description, or may be learned by practice of the presented embodiments of the disclosure.

In one or more embodiments, the positive electrode active material includes a first positive electrode active material that includes a lithium nickel-manganese-based composite oxide having a nickel content (e.g., amount) of greater than or equal to about 60 mol% based on 100 mol% of a total metal excluding lithium included in the first positive electrode active material and is in a form of a plurality of secondary particles each including a plurality of primary particles that are agglomerated (e.g., made by agglomerating a plurality of primary particles), a second positive electrode active material in a form of a plurality of single particles (e.g., each being in the form of a monolithic particle) including a lithium nickel-manganese-based composite oxide having a nickel content (e.g., amount) of greater than or equal to about 60 mol% based on 100 mol% of a total metal excluding lithium included in the second positive electrode active material, and a third positive electrode active material in a form of a plurality of particles including lithium manganese-based oxide.

In one or more embodiments, a positive electrode includes a positive electrode current collector and a positive electrode active material layer on the positive electrode current collector, wherein the positive electrode active material layer includes the aforementioned positive electrode active material.

In one or more embodiments, a rechargeable lithium battery includes the positive electrode, a negative electrode, and an electrolyte.

At least some of the above and other features of the invention are set out in the claims.

The positive electrode active material according to one or more embodiments, whose capacity is maximized or increased while minimizing or reducing a production cost, secures long cycle-life characteristics and is suppressed or reduced from a side reaction with an electrolyte at a high voltage. Accordingly, a rechargeable lithium battery, to which the positive electrode active material is applied, may exhibit high initial charge and discharge capacity and efficiency under high-voltage driving conditions and may realize long cycle-life characteristics.

### BRIEF DESCRIPTION OF DRAWINGS

The above and other aspects, features, and advantages of certain embodiments of the present disclosure will be more apparent from the following description taken in conjunction with the accompanying drawings.
FIG. 1 is a cross-sectional view schematically showing a rechargeable lithium battery according to one or more embodiments.
FIG. 2 is a scanning electron microscopy (SEM) image of the first positive electrode active material of Example 1 of the present disclosure.
FIG. 3 is an SEM image of the second positive electrode active material of Example 1 of the present disclosure.
FIG. 4 and FIG. 5 are each an SEM image of the third positive electrode active material of Example 1 of the present disclosure.

### DETAILED DESCRIPTION

Hereinafter, example embodiments will be described in more detail so that those of ordinary skill in the art may easily implement them. However, the present disclosure may be embodied in many different forms and is not construed as limited to the example embodiments set forth herein.

The terminology utilized herein is utilized to describe embodiments only, and is not intended to limit the present disclosure. As used herein, the singular forms "a," "an," and "the" are intended to include the plural forms as well, unless the context clearly indicates otherwise. Further, the utilization of "may" when describing embodiments of the present disclosure refers to "one or more embodiments of the present disclosure".

As utilized herein, "combination thereof" may refer to a mixture, a laminate, a composite, a copolymer, an alloy, a blend, a reaction product, and/or the like of the constituents.

Herein, it should be understood that terms such as "comprise(s)/comprising," "include(s)/including," or "have/has/having" are intended to designate the presence of an embodied feature, number, operation, element, and/or a (e.g., any suitable) combination thereof, but it does not preclude the possibility of the presence or addition of one or more other features, numbers, operations, elements, and/or a (e.g., any suitable) combination thereof.

In the drawings, the thickness of layers, films, panels, regions, and/or the like, may be exaggerated for clarity, and like reference numerals designate like elements throughout the present disclosure, and duplicative descriptions thereof may not be provided for conciseness. It will be understood that if (e.g., when) an element such as a layer, film, region, or substrate is referred to as being "on" another element, it may be directly on the other element or intervening elements may also be present. In contrast, if (e.g., when) an element is referred to as being "directly on" another element, there are no intervening elements present.

In one or more embodiments, "layer" herein includes not only a shape or a film formed on the whole surface if (e.g., when) viewed from a plan view, but also a shape or a film formed on a partial surface.

In one or more embodiments, an average particle diameter may be measured by a method well suitable (e.g. known) to those skilled in the art, for example, may be measured by a particle size analyzer, for example, HORIBA, LA-950 laser particle size analyzer, or may be measured by a transmission electron microscope (TEM) or a scanning electron microscope (SEM). In one or more embodiments, it may obtain an average particle diameter value by measuring it utilizing a dynamic light scattering method, performing data analysis, counting the number of particles for each particle size range, and calculating from the data. Unless otherwise defined, the average particle diameter may refer to the diameter (D₅₀) of particles having a cumulative volume of 50 volume% in a particle size distribution. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size. In one or more embodiments, as utilized herein, if (e.g., when) a definition is not otherwise provided, the average particle diameter refers to a diameter (D₅₀) of particles having a cumulative volume of 50 volume% in the particle size distribution that is obtained by measuring the size (diameter or length of the major axis) of about 20 particles at random in a scanning electron microscope image. In the present disclosure, when particles are spherical, "diameter" indicates an average particle diameter, and when the particles are non-spherical, the "diameter" indicates a major axis length.

Herein, "or" is not to be construed as an exclusive meaning, for example, "A or B" is construed to include A, B, A+B, and/or the like. Further, as utilized herein, the term "and/or" includes any and all combinations of one or more of the associated listed items. Expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

As utilized herein, the term "metal" is interpreted as a concept including ordinary metals, transition metals and metalloids (semi-metals).

### Positive Electrode Active Material

In one or more embodiments, a positive electrode active material includes a first positive electrode active material that includes a lithium nickel-manganese-based composite oxide having a nickel content (e.g., amount of nickel) of greater than or equal to about 60 mol% based on 100 mol% of a total metal excluding lithium included in the first positive electrode active material and is in a form of a plurality of secondary particles each including a plurality of primary particles (e.g., made by agglomerating a plurality of primary particles), a second positive electrode active material in a form of a plurality of single particles (e.g., each being in the form of a monolithic particle) including a lithium nickel-manganese-based composite oxide having a nickel content (e.g., amount) of greater than or equal to about 60 mol% based on 100 mol% of a total metal excluding lithium included in the second positive electrode active material, and a third positive electrode active material in a form of a plurality of particles including lithium manganese-based oxide.

Recently, as a price of cobalt, a rare metal, has sharply soared, there is a demand and desire for development of positive electrode active materials excluding the cobalt or including it in a reduced amount. Among those positive electrode active materials, positive electrode active materials with an olivine-based crystal structure such as lithium iron phosphate (LFP), lithium manganese phosphate (LMP), lithium manganese iron phosphate (LMFP), and/or the like have limitations in realizing relatively high capacity due to a small/low available lithium amount within the structure. Nickel-manganese-based positive electrode active materials with a layered structure exhibit excellent or suitable capacity and efficiency characteristics due to a large available lithium amount in the structure and thus may be suitable for high-capacity batteries. However, as cobalt, which plays a key role in the layered structure, is excluded, structural stability deteriorates and resistance increases, resulting in failing to secure long-term cycle-life characteristics. In addition, as the cobalt is excluded, the side reaction of the positive electrode active material with an electrolyte may be accelerated under high-voltage and high-temperature conditions, causing problems of increasing a gas generation amount and deteriorating cycle-life characteristics.

In one or more embodiments of the present disclosure, the first positive electrode active material in the form of secondary particles and the second positive electrode active material in the form of single particles, as particles including a lithium nickel-manganese-based composite oxide, are mixed with the third positive electrode active material including lithium manganese-based oxide, which is an inexpensive material, to propose a positive electrode active material realizing long-term cycle-life characteristics as well as high capacity and high energy density and exhibiting improved high-voltage performance.

An average particle diameter (D₅₀) of the secondary particles of the first positive electrode active material may be larger than an average particle diameter (D₅₀) of the single particles of the second positive electrode active material. In the present disclosure, the first positive electrode active material may be expressed as large particles, and the second positive electrode active material may be expressed as small particles. The average particle diameter (D₅₀) of the secondary particles of the first positive electrode active material may be larger than an average particle diameter (D₅₀) of the third positive electrode active material. The average particle diameter (D₅₀) of the third positive electrode active material may be equal to or larger than the average particle diameter (D₅₀) of the single particles of the second positive electrode active material. For a lithium nickel-manganese-based oxide, it may maximize or increase capacity and energy density and improve high-voltage characteristics by appropriately or suitably mixing large particles in a form of secondary particles and small particles in the form of single particles and additionally mixing lithium manganese-based oxide.

In one or more embodiments, the average particle diameter refers to a diameter (D₅₀) of particles having a cumulative volume of 50 volume% in a particle size distribution that is obtained by measuring the size (diameter or length of the major axis) of about 20 particles at random in a scanning electron microscope image.

In one or more embodiments, the average particle diameter (D₅₀) of secondary particles of the first positive electrode active material may be, for example, about 10 micron or micrometer (µm) to about 20 µm, about 10 µm to about 18 µm, or about 12 µm to about 16 µm. The average particle diameter (D₅₀) of single particles of the second positive electrode active material may be, for example, about 0.5 µm to about 8 µm, about 1 µm to about 7 µm, about 1.5 µm to about 6 µm, or about 2 µm to about 5 µm. The average particle diameter (D₅₀) of the third positive electrode active material may be about 5 µm to about 12 µm, for example about 6 µm to about 11 µm, or about 7 µm to about 10 µm. If the average particle diameter of each positive electrode active material satisfies the above range, relatively high capacity may be achieved and energy density may be maximized or increased.

In one or more embodiments, based on a total weight, 100 wt%, of the first positive electrode active material, the second positive electrode active material, and the third positive electrode active material, the first positive electrode active material may be included in about 60 wt% to about 90 wt%, the second positive electrode active material may be included in about 5 wt% to about 35 wt%, and the third positive electrode active material may be included in an amount of about 5 wt% to about 35 wt%. In some embodiments, based on a total weight, 100 wt%, of the first positive electrode active material, the second positive electrode active material, and the third positive electrode active material, the first positive electrode active material may be included in an amount of about 60 wt% to about 85 wt%, the second positive electrode active material may be included in an amount of about 10 wt% to about 25 wt%, and the third positive electrode active material may be included in an amount of about 5 wt% to about 20 wt%. When the mixing ratio of each positive electrode active material satisfies the above ranges, energy density may be further increased while increasing capacity.

The lithium nickel-manganese-based composite oxide of the first positive electrode active material and the lithium nickel-manganese-based composite oxide of the second positive electrode active material may be the same or different from each other. In each lithium nickel-manganese-based composite oxide, a nickel content (e.g., amount) is greater than or equal to about 60 mol%, for example, about 60 mol% to about 80 mol%, about 65 mol% to about 80 mol%, about 70 mol% to about 80 mol%, about 60 mol% to about 79 mol%, about 60 mol% to about 78 mol%, or about 60 mol% to about 75 mol% based on 100 mol% of a total metal excluding lithium in the lithium nickel-manganese-based composite oxide. When the nickel content (e.g., amount) satisfies the above ranges, relatively high capacity may be achieved and structural stability may be increased even if the cobalt content (e.g., amount) is reduced.

In one or more embodiments, a manganese content (e.g., amount) may be, for example, about 10 mol% to about 40 mol%, for example, about 10 mol% to about 39 mol%, about 10 mol% to about 35 mol%, about 10 mol% to about 30 mol%, about 10 mol% to about 29 mol%, about 15 mol% to about 39 mol%, about 20 mol% to about 39 mol%, or about 20 mol% to about 30%, based on 100 mol% of a total metal excluding lithium in the lithium nickel-manganese-based composite oxide. When the manganese content (e.g., amount) satisfies the above ranges, the positive electrode active material may improve structural stability while realizing high capacity.

In one or more embodiments, in each first positive electrode active material and second positive electrode active material, the respective lithium nickel-manganese-based composite oxide may be a lithium nickel-manganese-aluminium-based composite oxide that further includes aluminium in addition to nickel and manganese. When the composite oxide includes aluminium, it is advantageous to maintain a stable layered structure even if the cobalt element is excluded from the structure. The aluminium content (e.g., amount), based on 100 mol% of a total metal excluding lithium in the lithium nickel-manganese-aluminium-based composite oxide, may be greater than or equal to about 0.1 mol%, greater than or equal to about 0.5 mol%, or greater than or equal to about 1 mol%, for example, about 1 mol% to about 3 mol%, about 1 mol% to about 2.5 mol%, about 1 mol% to about 2 mol%, or about 1 mol% to about 1.9 mol%. If the aluminium content (e.g., amount) satisfies the above ranges, a stable layered structure may be maintained even if cobalt is excluded, the problem of structure collapse due to charging and discharging may be suppressed or reduced, and long cycle-life characteristics of the positive electrode active material may be realized.

The lithium nickel-manganese-based composite oxide of the first positive electrode active material and the lithium nickel-manganese-based composite oxide of the second positive electrode active material may each independently be represented by Chemical Formula 1.

**Chemical Formula 1** **Liₐ₁Niₓ₁Mn_{y1}Al_{z1}M¹_{w1}O_{2-b1}X_{b1}**

In Chemical Formula 1, 0.9≤a1≤1.8, 0.6≤x1≤0.8, 0.1≤y1≤0.4, 0≤z1≤0.03, 0 ≤w1≤0.3, 0.9≤x1+y1+z1+w1≤1.1, and 0≤b1≤0.1, M¹ may be one or more elements selected from among boron (B), barium (Ba), calcium (Ca), cerium (Ce), chromium (Cr), iron (Fe), magnesium (Mg), molybdenum (Mo), niobium (Nb), silicon (Si), tin (Sn), strontium (Sr), titanium (Ti), vanadium (V), tungsten (W), yttrium (Y), and zirconium (Zr), and X may be one or more elements selected from among fluorine (F), phosphorous (P), and sulfur (S).

In Chemical Formula 1, in some embodiments, 0.9≤a1≤1.5, or 0.9≤a1≤1.2. In one or more embodiments, the lithium nickel-manganese composite oxide represented by Chemical Formula 1 may include aluminium, in these embodiments, it may satisfy 0.6≤x1≤0.8, 0.1≤y1≤0.39, 0.01≤z1≤0.03, and 0≤w1≤0.29, for example, 0.6≤x1≤0.8, 0.1≤y1≤0.39, 0.01<z1≤0.03, and 0≤w1≤0.29.

In Chemical Formula 1, for example, in some embodiments, 0.6≤x1≤0.79, 0.6≤x1≤0.78, 0.6≤x1≤0.75, 0.65≤x1≤0.8, or 0.7≤x1≤0.79; 0.1≤y1≤0.35, 0.1≤y1≤ 0.30, 0.1≤y1≤0.29, 0.15≤y1≤0.39, or 0.2≤y1≤0.3; 0.01≤z1≤0.025, 0.01<z1≤0.02, or 0.01<z1≤0.019; and 0≤w1≤0.28, 0≤w1≤0.27, 0≤w1≤0.26, 0≤w1≤0.25, 0≤w1≤0.24, 0 ≤w1≤0.23, 0≤w1≤0.22, 0≤w1≤0.21, 0≤w1≤0.2, 0≤w1≤0.15, 0≤w1≤0.1, or0≤w1≤ 0.09.

In one or more embodiments, the lithium nickel-manganese-based composite oxide may be a cobalt-free compound that does not include cobalt or includes a very small amount of cobalt. For example, in the lithium nickel-manganese-based composite oxide of the first positive electrode active material and the lithium nickel-manganese-based composite oxide of the second positive electrode active material, a cobalt content (e.g., amount) may each independently be about 0 mol% to about 0.01 mol% based on 100 mol% of a total metal excluding lithium included in each respective lithium nickel-manganese composite oxide.

### First Positive Electrode Active Material

According to one or more embodiments, in the secondary particles excluding a coating layer of the first positive electrode active material, a concentration of aluminium (if present) may be substantially uniform. For example, the aluminium may be uniformly (substantially uniformly) dispersed within the particle without a concentration gradient from the center of a particle to a surface direction within the particle nor a concentration difference between outside and inside the particle (e.g., between particles). This is a structure obtained by not additionally doping the aluminium during the synthesis of the positive electrode active material but utilizing an aluminium raw material to synthesize a nickel-manganese-aluminium-based hydroxide as a precursor and utilizing the precursor to synthesize the composite oxide. For example, in one or more embodiments, the aluminium content (e.g., amount) inside each of the primary particles may be the same or similar regardless of a location of each of the primary particles. When one primary particle is selected from any position of the cross-section of one secondary particle to measure the aluminium content (e.g., amount) not on the interface of the primary particle but inside the primary particle, the aluminium content (e.g., amount) may be the same/similar/substantially uniform regardless of a location of the primary particle, that is, whether or not the primary particle is close to the center of the secondary particle or to the surface of the secondary particle. In this structure, even though cobalt is absent or present in a very small amount, the layered structure may be stably maintained, and neither aluminium by-products nor aluminium agglomerates are generated, concurrently (e.g., simultaneously) improving capacity, efficiency, and cycle-life characteristics of the positive electrode active material.

The first positive electrode active material according to one or more embodiments may further include a coating layer on (e.g., arranged on) the surface of the secondary particle and containing aluminium. In the first positive electrode active material, based on 100 mol% of a total metal excluding lithium, an aluminium content (e.g., amount) of the coating layer may be about 0.1 mol% to about 2 mol%. The first positive electrode active material according to one or more embodiments may further include a coating layer on (e.g., arranged on) the surface of the secondary particle and containing aluminium and zirconium. The first positive electrode active material, which includes an aluminium-zirconium-rich layer on the surface, may be effectively suppressed or reduced from a side reaction with an electrolyte solution at a relatively high voltage, improving capacity and cycle-life characteristics at a relatively high voltage.

In the first positive electrode active material, based on 100 mol% of a total metal excluding lithium, an aluminium content (e.g., amount) of the coating layer may be about 0.1 mol% to about 2 mol% and a zirconium content (e.g., amount) of the coating layer may be about 0.05 mol% to about 1 mol%. In some embodiments, in the first positive electrode active material, the aluminium content (e.g., amount) of the coating layer may be for example about 0.2 mol% to about 1.9 mol%, about 0.3 mol% to about 1.8 mol%, about 0.5 mol% to about 1.5 mol%, or about 0.8 mol% to about 1.3 mol%. The contents of aluminium, zirconium, and/or the like in the coating layer may be, for example, measured through SEM-EDS analysis of the surface or cross-section of the positive electrode active material. When the aluminium content (e.g., amount) in the coating layer satisfies the ranges, the coating layer may have a substantially uniform and thin thickness, and resistance of the positive electrode active material may not increase, and in addition, a side reaction thereof with an electrolyte may be effectively suppressed or reduced, improving cycle-life characteristics of a rechargeable lithium battery at a relatively high voltage.

In one or more embodiments, in the first positive electrode active material, the zirconium content (e.g., amount) of the coating layer may be for example, about 0.1 mol% to about 1 mol%, about 0.1 mol% to about 0.9 mol%, about 0.1 mol% to about 0.8 mol%, or about 0.1 mol% to about 0.6 mol%. When the zirconium content (e.g., amount) satisfies the ranges, a satisfactory coating layer may be formed on the positive electrode active material without deteriorating capacity or increasing resistance, which may effectively suppress or reduce a side reaction with an electrolyte under relatively high voltage driving conditions, additionally improving capacity characteristics and cycle-life characteristics.

In one or more embodiments, the coating layer of the first positive electrode active material may further include yttrium in addition to aluminium and zirconium, wherein a content (e.g., amount) of the yttrium may be about 0.1 mol% to about 1 mol% based on about 100 mol% of a total metal excluding lithium of the first positive electrode active material. In one or more embodiments, based on 100 mol% of a total metal excluding lithium in the first positive electrode active material the coating layer may comprise about 0.05 mol% to about 1 mol% of zirconium and/or about 0.05 mol% to about 1 mol% of yttrium.

The coating layer of the first positive electrode active material may be formed as a film continuously wrapping the surface of each of the secondary particles, for example, a shell wrapping the entire surface of each of the secondary particles. This is distinguished from a structure that the coating layer is coated on a portion of the surface of each of the secondary particles. According to one or more embodiments, because the coating layer is formed to completely cover the surface of each of the secondary particles but still has a very thin and substantially uniform thickness, the positive electrode active material may neither exhibit an increase in resistance nor deteriorate capacity but improve structural stability, effectively suppress or reduce a side reaction with an electrolyte, reduce a gas generation amount, and realize long-term cycle-life characteristics.

In one or more embodiments, a thickness of the coating layer of the first positive electrode active material may be about 30 nanometers (nm) to about 500 nm, for example, about 30 nm to about 450 nm, about 30 nm to about 400 nm, about 30 nm to about 350 nm, about 30 nm to about 300 nm, about 30 nm to about 250 nm, about 30 nm to about 200 nm, about 30 nm to about 150 nm, about 50 nm to about 500 nm, about 80 nm to about 500 nm, or about 100 nm to about 500 nm. When the coating layer satisfies the thickness ranges, the structural stability of the positive electrode active material may be improved without increasing resistance and/or reducing capacity due to the coating, and the side reaction with the electrolyte may be effectively suppressed or reduced. The thickness of the coating layer may be measured through, for example, SEM, TEM, time-of-flight secondary ion mass spectrometry (TOF-SIMS), X-ray photoelectron spectroscopy (XPS), or energy dispersive spectroscopy (EDS) analysis, for example, through TEM-EDS line profile.

The coating layer of the first positive electrode active material has a thickness of tens or hundreds of nano meters and thus a thin and substantially uniform thickness. For example, in one or more embodiments, the coating layer has a thickness deviation of less than or equal to about 20%, less than or equal to about 18%, or less than or equal to about 15% within one positive electrode active material particle. Herein, the thickness deviation of the coating layer refers to a thickness of the coating layer within one positive electrode active material particle. The thickness deviation of the coating layer may be, for example, obtained by measuring each thickness at about 10 points from an electron microscope image of the cross-section of one positive electrode active material particle, calculating an arithmetic average thereof, and then, dividing an absolute value of a difference between one data set and the arithmetic average by the arithmetic average and multiplying by 100. When the thickness deviation or standard deviation of the coating layer satisfies the ranges, on the positive electrode active material particle surface, the coating layer may be well formed as a film with a substantially uniform thickness and thus improve structural stability of the positive electrode active material and effectively suppress or reduce a side reaction with an electrolyte and minimize or reduce an increase in resistance or capacity deterioration due to the coating.

In some embodiments, the aluminium may be diffused into the secondary particle during formation of the coating layer. Accordingly, the positive electrode active material according to one or more embodiments may further include a grain boundary coating portion located on the surface of each of the primary particles inside the secondary particle and containing the aluminium. The inside of the secondary particle may refer to the entire internal portion excluding the surface of the secondary particle or may refer to a region to about 60 length% of a radius of the secondary particle from the center of the secondary particle toward the surface of the secondary particle. The grain boundary coating portion is a separate concept from the coating layer on the secondary particle surface and refers to a coating portion on the surface of each of the primary particles inside the secondary particle. The presence of the grain boundary coating portion may be checked and confirmed by utilizing an SEM-EDS analysis of the cross-section of the positive electrode active material and/or the like. When the aluminium grain boundary coating portion is formed, the positive electrode active material may be further structurally stabilized, and cycle-life characteristics may be improved.

The aluminium content (e.g., amount) in the grain boundary coating portion is not particularly limited but, for example, may be smaller than the aluminium content (e.g., amount) in the coating layer.

In contrast, in one or more embodiments, the aluminium content (e.g., amount) of the coating layer of the first positive electrode active material may be larger than that of a coating layer of the second positive electrode active material described in more detail later. For example, in one or more embodiments, the aluminium content (e.g., amount) of the coating layer of the first positive electrode active material and that of the coating layer of the second positive electrode active material may have a mole ratio of about 5:1 to about 2:1 or about 4:1 to about 2:1. Herein, the aluminium in the coating layers of the first positive electrode active material and the second positive electrode active material may not act as resistance but may maximize or increase capacity and cycle-life characteristics as well as improve each structural stability.

### Second Positive Electrode Active Material

The second positive electrode active material is in the single particle form (i.e., in the form of single particles), the single particle exists alone without a grain boundary within the particle, is composed of one particle, and has a single particle, a monolith structure, a one body structure, or a non-agglomerated particle, in which particles are not agglomerated with each other but exist as an independent phase in terms of morphology, and may be expressed as a single particle (one body particle, single grain), for example, as a single crystal.

In one or more embodiments, the second positive electrode active material may further include a coating layer including aluminium and on (e.g., arranged on) the surface of the single particle. In these embodiments, the initial discharge capacity and cycle-life characteristics of the positive electrode active material at relatively high voltage may be improved.

In the coating layer of the second positive electrode active material, an aluminium content (e.g., amount) may be about 0.1 mol% to about 2 mol%, for example, about 0.2 mol% to about 1.9 mol%, about 0.3 mol% to about 1.8 mol%, about 0.5 mol% to about 1.5 mol%, or about 0.8 mol% to about 1.3 mol%, based on 100 mol% of a total metal excluding lithium in the second positive electrode active material. This refers only to the content (e.g., amount) of aluminium included in the coating layer of the second positive electrode active material, separately from the aluminium that may be included within the single particle. The aluminium content (e.g., amount) in the coating layer may be measured, for example, through SEM-EDS analysis of the surface or cross-section of the positive electrode active material. If (e.g., when) the aluminium content (e.g., amount) in the coating layer of the second positive electrode active material satisfies the ranges, the coating layer may have a substantially uniform and thin thickness, which may not increase resistance of the positive electrode active material and effectively suppress or reduce a side reaction with the electrolyte and thereby, improve cycle-life characteristics of a rechargeable lithium battery under relatively high-voltage and relatively high-temperature conditions. For example, if (e.g., when) the aluminium content (e.g., amount) of the coating layer of the second positive electrode active material is excessive, the coating layer may not be substantially uniform, or resistance may increase, thereby deteriorating charge and discharge efficiency and cycle-life characteristics, but if (e.g., when) the aluminium content (e.g., amount) of the coating layer of the second positive electrode active material is too small, the coating layer may not have an appropriate or suitable thickness, deteriorating an effect of suppressing or reducing a side reaction with an electrolyte.

In one or more embodiments, the coating layer of the second positive electrode active material may further include yttrium, which may further suppress or reduce the side reaction of the positive electrode active material with the electrolyte solution at a high voltage, resultantly improving cycle-life characteristics. An yttrium content (e.g., amount) in the coating layer of the second positive electrode active material may be about 0.1 mol% to about 1 mol%, for example, about 0.1 mol% to about 0.9 mol%, about 0.1 mol% to about 0.8 mol%, about 0.1 mol% to about 0.6 mol%, about 0.1 mol% to about 0.4 mol%, or about 0.1 mol% to about 0.3 mol%, based on 100 mol% of a total metal excluding lithium in the second positive electrode active material. When the yttrium content (e.g., amount) satisfies the ranges, a satisfactory coating layer may be formed on the second positive electrode active material without deteriorating capacity or increasing resistance and thus effectively suppress or reduce the side reaction with the electrolyte and effectively reduce a gas generation amount under high-voltage or high-temperature conditions.

The coating layer of the second positive electrode active material may be in the form of a film that continuously surrounds the surface of a single particle (e.g., the surface of each single particle), or, for example, may be in the form of a shell that surrounds the entire surface of the single particle (e.g., the surface of each single particle). This is distinct from a structure in which only portion of the surface of the particle is partially coated. The coating layer according to one or more embodiments may be formed to have a very thin and substantially uniform thickness as well as entirely cover the surface of the single particle, which may neither increase resistance of the positive electrode active material nor deteriorate capacity but exhibits improved structural stability and may be effectively suppressed or reduced from a side reaction with the electrolyte, resultantly realizing long cycle-life characteristics at a high voltage.

In one or more embodiments, a thickness of the coating layer of the second positive electrode active material may be about 30 nm to about 500 nm, for example, about 30 nm to about 450 nm, about 30 nm to about 400 nm, about 30 nm to about 350 nm, about 30 nm to about 300 nm, about 30 nm to about 250 nm, about 30 nm to about 200 nm, about 30 nm to about 150 nm, about 50 nm to about 500 nm, about 80 nm to about 500 nm, or about 100 nm to about 500 nm. When the coating layer of the second positive electrode active material satisfies the thickness ranges, the structural stability of the positive electrode active material may be improved without increasing resistance and/or reducing capacity due to the coating, and the side reaction with the electrolyte may be effectively suppressed or reduced. The thickness of the coating layer may be measured through, for example, SEM, TEM, TOF-SIMS, XPS, or EDS analysis, for example, through TEM-EDS line profile.

The coating layer of the second positive electrode active material has a thin and substantially uniform thickness of tens to hundreds of nanometers. For example, in one or more embodiments, within one positive electrode active material particle (e.g., the single particle), the coating layer may have a thickness deviation of less than or equal to about 20%, less than or equal to about 18%, or less than or equal to about 15%. Herein, the thickness deviation of the coating layer refers to a thickness of a coating layer on one positive electrode active material particle. The thickness deviation of the coating layer may be calculated, for example, by measuring each thickness at about 10 points from an electron microscope image of the cross-section of one positive electrode active material particle to obtain an arithmetic average and then, dividing an absolute value of a difference between one data set and the arithmetic average by the arithmetic average and multiplying by 100. When the coating layer has a thickness deviation or standard deviation within the ranges, the coating layer is well formed with a substantially uniform thickness on the surface of the positive electrode active material particle, which may improve structural stability of the positive electrode active material, effectively suppress or reduce a side reaction with an electrolyte, and minimize or reduce an increase in resistance or capacity deterioration.

In the coating layer of the second positive electrode active material, aluminium may exist in the form of a continuous (e.g., substantially continuous) film, while yttrium may exist in the form of an island (e.g., separate islands), due to characteristics of each element.

In one or more embodiments, the aluminium and the yttrium may be mixed within one coating layer, but the aluminium still may exist in the form of a continuous (e.g., substantially continuous) layer, while the yttrium may exist in the form of an island, but embodiments of the present disclosure are not limited to the forms.

In one or more embodiments, aluminium and yttrium may form (or provide) separate layers. For example, in one or more embodiments, the second positive electrode active material may include a first coating layer on (e.g., arranged on) the surface of a single particle and including aluminium, and a second coating layer on (e.g., arranged on) the first coating layer and including yttrium. The first coating layer in the form of a thin film may be formed as aluminium is first attached or absorbed to the surface of the single particle, and then yttrium may be coated on it to form (or provide) the second coating layer. Of course, in some embodiments, aluminium and yttrium may be mixed in the first coating layer and the second coating layer, but the first coating layer may be an aluminium-rich coating layer mainly composed of aluminium, and the second coating layer may be an yttrium-rich coating layer mainly composed of yttrium. In these embodiments, the yttrium may exist in the form of islands in the second coating layer, but there is no particular limitation.

In one or more embodiments, thicknesses of the first coating layer and the second coating layer are not particularly limited. However, the thickness of the first coating layer may be about 10 nm to about 200 nm, for example, about 20 nm to about 200 nm, about 30 nm to about 200 nm, or about 30 nm to about 180 nm. The thickness of the second coating layer may be about 20 nm to about 300 nm, for example, about 20 nm to about 250 nm, about 20 nm to about 200 nm, about 30 nm to about 300 nm, or about 50 nm to about 300 nm. When each of the thickness of the first coating layer and the thickness of the second coating layer satisfies the above ranges, the structural stability of the positive electrode active material may be improved without increasing resistance and/or decreasing capacity due to the coating, and the cycle-life characteristics at relatively high voltage may be improved by effectively suppressing or reducing side reactions with the electrolyte.

### Third Positive Electrode Active Material

The third positive electrode active material may be in a form of a single particle or a plurality of secondary particles each including a plurality of primary particles that are agglomerated (e.g., made by agglomerating a plurality of primary particles).

The lithium manganese-based oxide of the third positive electrode active material may be, for example, a spinel-structured lithium manganese oxide with LiMn₂O₄ as a basic composition. In one or more embodiments, the lithium manganese-based oxide may further include, for example, aluminium, magnesium, yttrium, and/or a (e.g., any suitable) combination thereof in addition to manganese, and may not include (e.g., may exclude) cobalt or may include a very small amount of cobalt.

For example, in one or more embodiments, the lithium manganese-based oxide of the third positive electrode active material may be represented by Chemical Formula 3.

**Chemical Formula 3** **Liₐ₃Mnₓ₃M³_{y3}O_{4-b3}X_{b3}**

In Chemical Formula 3, 0.9≤a3≤1.8, 1.7≤x3≤2, 0≤y3≤0.3, 1.9≤x3+y3≤2.1, and 0≤b3≤0.1, M³ may be one or more elements selected from among Al, B, Ba, Ca, Ce, Cr, Fe, Mg, Mo, Nb, Si, Sn, Sr, Ti, V, W, Y, and Zr, and X may be one or more elements selected from among F, P, and S.

In Chemical Formula 3, in one or more embodiments, 1.8≤x3≤2, 0≤y3≤0.2, or 1.9≤x3≤2, 0≤y3≤0.1, or 1.7≤x3<2, 0<y3≤0.3.

In one or more embodiments, the lithium manganese-based oxide of the third positive electrode active material may be represented by Chemical Formula 4.

**Chemical Formula 4** **Liₐ₄Mnₓ₄Al_{y4}Mg_{z4}M⁴_{w4}O_{4-b4}X_{b4}**

In Chemical Formula 4, 0.9≤a4≤1.8, 1.7≤x4<2.0, 0<y4≤0.015, 0<z4≤0.010, 0≤w4<0.3, 1.9≤x4+y4+z4+w4≤2.1, and 0≤b4≤0.1, M⁴ may be one or more elements selected from among B, Ba, Ca, Ce, Cr, Fe, Mo, Nb, Si, Sn, Sr, Ti, V, W, Y, and Zr, and X may be one or more elements selected from among F, P, and S.

In one or more embodiments, in the lithium manganese-based oxide, based on 100 mol% of a total metal excluding lithium, Al may be included in an amount of about 0 mol% to about 1.5 mol%, about 0.01 mol% to about 1.0 mol%, or about 0.1 mol% to about 0.8 mol%, and Mg may be included in an amount of about 0 mol% to about 1.0 mol%, about 0.01 mol% to about 0.9 mol%, or about 0.1 mol% to about 0.8 mol%.

In one or more embodiments, third positive electrode active material may further include a coating layer on (e.g., arranged on) the surface of the particle and including aluminium. Herein, the positive electrode active material may be effectively suppressed or reduced from a side reaction with an electrolyte at a relatively high voltage and thus improve cycle-life characteristics. In the third positive electrode active material, the coating layer may include about 0.01 mol% to about 1 mol% of the aluminium or, for example, about 0.05 mol% to about 0.5 mol% based on 100 mol% of total metals excluding lithium included in the third positive electrode active material.

In the positive electrode active material according to one or more embodiments, a content (e.g., amount) of cobalt may be, for example, less than or equal to about 0.01 mol%, less than or equal to about 0.005 mol%, less than or equal to about 0.001 mol%, or, for example, about 0 mol% to about 0.01 mol% based on about 100 mol% of metals excluding lithium included in the positive electrode active material. According to one or more embodiments, the positive electrode active material may be, for example, a cobalt-free positive electrode active material.

In one or more embodiments, the positive electrode active material according to one or more embodiments may not include (e.g., may exclude) sodium. In general, sodium ions may be utilized in a process of preparing a positive electrode active material, but according to a preparing method described in more detail later, positive electrode active material particles with a stable structure and a coating layer with a substantially uniform thickness may be formed without utilizing the sodium ions.

### Method of Preparing Positive Electrode Active Material

In one or more embodiments, a method of preparing a positive electrode active material may include (i) mixing and heat-treating a nickel-manganese-based composite hydroxide having a nickel content (e.g., amount of nickel) of greater than or equal to about 60 mol% based on 100 mol% of the total metals of the nickel-manganese-based composite hydroxide and a lithium raw material to prepare a first positive electrode active material in a form of secondary particles each formed by agglomerating a plurality of primary particles, (ii) mixing and heat-treating a nickel-manganese-based composite hydroxide having a nickel content (e.g., amount) of greater than or equal to about 60 mol% based on 100 mol% of the total metals of the nickel-manganese-based composite hydroxide and a lithium raw material to prepare a second positive electrode active material in a form of single particles, (iii) preparing a third positive electrode active material including lithium manganese-based oxide, and (iv) mixing the first positive electrode active material, the second positive electrode active material, and the third positive electrode active material.

In the preparation process of each of the first positive electrode active material and the second positive electrode active material, the nickel-manganese-based composite hydroxide may not include (e.g., may exclude) cobalt or may include a trace amount of cobalt, for example, may be a cobalt-free nickel-manganese-based composite hydroxide, for example, a cobalt-free nickel-manganese-aluminium-based composite hydroxide. The nickel-manganese-based composite hydroxide may be prepared by a general coprecipitation method.

The nickel content (e.g., amount) in the nickel-manganese-based composite hydroxide may be greater than or equal to about 60 mol%, for example, about 60 mol% to about 80 mol%, about 65 mol% to about 80 mol%, about 70 mol% to about 80 mol%, about 60 mol% to about 79 mol%, about 60 mol% to about 78 mol%, or about 60 mol% to about 75 mol%, based on 100 mol% of a total metal in the nickel-manganese-based composite hydroxide. If (e.g., when) the nickel content (e.g., amount) satisfies the above ranges, relatively high capacity may be achieved and structural stability may be increased even if the cobalt content (e.g., amount) is reduced.

The manganese content (e.g., amount of manganese) in the nickel-manganese-based composite hydroxide may be about 10 mol% to about 40 mol%, about 10 mol% to about 39 mol%, about 10 mol% to about 35 mol%, about 10 mol% to about 30 mol%, about 10 mol% to about 29 mol%, about 15 mol% to about 39 mol%, about 20 mol% to about 39 mol%, or about 20 mol% to about 30%, based on 100 mol% of a total metal in the nickel-manganese-based composite hydroxide.

In one or more embodiments, if (e.g., when) the nickel-manganese-based composite hydroxide further includes aluminium, the aluminium content (e.g., amount of aluminium) may be greater than or equal to about 0.1 mol%, greater than or equal to about 0.5 mol%, or greater than or equal to about 1 mol%, for example, about 1 mol% to about 3 mol%, about 1 mol% to about 2.5 mol%, about 1 mol% to about 2 mol%, or about 1 mol% to about 1.9 mol%, based on 100 mol% of a total metal in the nickel-manganese-based composite hydroxide. If (e.g., when) the manganese and aluminium contents of the composite hydroxide satisfy the above ranges, relatively high capacity may be realized while structural stability of the positive electrode active material may be increased, and production price may be lowered to increase economic efficiency.

In the nickel-manganese-based composite hydroxide, the cobalt content (e.g., amount) may be less than or equal to about 0.01 mol%, less than or equal to about 0.005 mol%, or less than or equal to about 0.001 mol%, based on 100 mol% of the total metal in the nickel-manganese-based composite hydroxide. This nickel-manganese-based composite hydroxide may be economical as it avoids the increase in unit cost caused by cobalt, maximizes capacity, and improves structural stability.

As an example, in one or more embodiments, the nickel-manganese-based composite hydroxide may be represented by Chemical Formula 2.

**Chemical Formula 2** **Niₓ₂Mn_{y2}Al_{z2}M²_{w2}(OH)₂**

In Chemical Formula 2, 0.6≤x2≤0.8, 0.1≤y2≤0.4, 0≤z2≤0.03, 0≤w2≤0.3, and 0.9≤x2+y2+z2+w2≤1.1, and M² may be one or more elements selected from among B, Ba, Ca, Ce, Cr, Fe, Mg, Mo, Nb, Si, Sn, Sr, Ti, V, W, Y, and Zr.

In Chemical Formula 2, for example, in some embodiments, 0.6≤x2≤0.8, 0.1 ≤y2≤0.39, 0.01≤z2≤0.03, and 0≤w2≤0.29.

In one or more embodiments, in the preparation of the first positive electrode active material, aluminium is not additionally doped, but an aluminium raw material may be utilized to prepare a precursor, so that a nickel-manganese-aluminium-based composite hydroxide, in which aluminium is uniformly (substantially uniformly) dispersed in the structure, may be utilized as the precursor. When such a precursor is utilized, the positive electrode active material may stably maintain a layered structure without cobalt despite repeated charges and discharges, and aluminium byproducts or aluminium aggregates may not be formed, resultantly, improving capacity and efficiency characteristics and cycle-life characteristics of the positive electrode active material.

In one or more embodiments, in the preparation of the first positive electrode active material, the nickel-manganese-based composite hydroxide and a lithium raw material may be mixed in a mole ratio of about 1:0.9 to about 1:1.8, for example, about 1:0.9 to about 1:1.5 or about 1:0.9 to about 1:1.2. After the mixing, a heat treatment may be performed under an oxygen atmosphere, for example, at about 750 °C to about 950 °C, or about 780 °C to about 900 °C, or about 810 °C to about 890 °C, for about 2 hours to about 20 hours or about 4 hours to about 12 hours. Through the heat treatment, lithium nickel-manganese-based composite oxide may be obtained. The obtained composite oxide may include nickel in an amount of about 60 mol% or more, for example, about 60 mol% to about 80 mol%, but include no cobalt or include the cobalt in a very small amount of less than or equal to about 0.01 mol%, based on about 100 mol% of total metals excluding lithium in the lithium nickel-manganese-based composite oxide.

The method of preparing the positive electrode active material according to one or more embodiments may further include a coating process after obtaining the lithium nickel-manganese-based composite oxide during the preparation of the first positive electrode active material. The lithium nickel-manganese-based composite oxide has a significantly different residual lithium content (e.g., amount) and different surface characteristics from an oxide with other compositions, for example, a conventional nickel-based oxide such as a lithium nickel-cobalt-manganese-based composite oxide or a lithium nickel-cobalt-aluminium-based composite oxide, and/or the like, conventional coating methods utilized in the art may not succeed in forming (or providing) a good or suitable coating layer thereon in the form of a substantially uniform film. One or more embodiments of the present disclosure provide a method of improving high-voltage characteristics by forming (or providing) the coating layer with a substantially uniform and very thin thickness on the surface of lithium nickel-manganese-based composite oxide having a very small cobalt content (e.g., amount) and a nickel content (e.g., amount) of about 60 mol% or more. For example, after adding an aluminium raw material to an aqueous solvent, the lithium nickel-manganese-based composite oxide is added thereto and then, mixed, dried, and heat-treated again to form (or provide) the coating layer according to one or more embodiments. This may be a wet coating method.

The aqueous solvent may include distilled water, an alcohol-based solvent, and/or a (e.g., any suitable) combination thereof. The aluminium raw material may include, for example, aluminium nitrate, aluminium sulfate, aluminium carbonate, aluminium hydroxide, and/or a (e.g., any suitable) combination thereof. For example, in one or more embodiments, the aluminium raw material may include aluminium sulfate, and in these embodiments, it is advantageous to form (or provide) a coating layer with a substantially uniform thickness on the surface of the lithium nickel-manganese-based composite oxide particles. An aluminium content (e.g., amount) in the aluminium raw material may be designed to be about 0.1 mol% to about 2 mol%, for example, about 0.2 mol% to about 1.9 mol%, about 0.3 mol% to about 1.8 mol%, about 0.5 mol% to about 1.5 mol%, or about 0.8 mol% to about 1.3 mol%, based on 100 mol% of a total metal excluding lithium in the first positive electrode active material.

A solution in which aluminium raw materials are mixed in an aqueous solvent may have a pH of about 1.5 to about 3.5, for example, about 2.0 to about 3.4, about 2.5 to about 3.3, about 2.7 to about 3.3, or about 2.9 to about 3.2. Dropping and mixing the lithium nickel-manganese-based composite oxide into an aqueous solvent mixed with the aluminium raw material may be carried out for about 5 minutes to about 80 minutes, about 5 minutes to about 60 minutes, or about 5 minutes to about 40 minutes. After the stirring, the mixed solution may have a pH of about 4.5 to about 8.5, for example, about 5.0 to about 8.0, about 5.5 to about 7.5, or about 6.0 to about 7.0. When these conditions are satisfied, it is advantageous to form (or provide) a coating layer with a substantially uniform thickness.

Drying after the mixing process may be understood as a process of removing the solvent and may be carried out, for example, at about 40 °C to about 240 °C, about 100 °C to about 220 °C, or about 150 °C to about 200 °C. The reheat treatment may be understood as a process of forming (or providing) a coating layer on the surface of lithium nickel-manganese-based oxide particles, for example, in an oxygen atmosphere in a temperature range of about 700 °C to about 850 °C, about 750 °C to about 840 °C, or about 800 °C to about 830 °C, for about 2 to about 20 hours, or about 3 to about 10 hours.

In order to coat zirconium as well as the aluminium, after adding a zirconium raw material to a product obtained after the drying, a heat treatment may be performed again. The zirconium raw material may be, for example, zirconium oxide, which may be added to have a zirconium content (e.g., amount) of about 0.05 mol% to about 1 mol% based on about 100 mol% of total metals excluding lithium in the first positive electrode active material.

In the preparation of the second positive electrode active material, the nickel-manganese-based composite hydroxide and the lithium raw material may be mixed in a mole ratio of about 1:0.9 to about 1:1.8, for example, about 1:0.9 to about 1:1.5 or about 1:0.9 to about 1:1.2. After the mixing, a heat treatment may be performed under an oxygen atmosphere, for example, at about 750 °C to about 950 °C, about 780 °C to about 900 °C, or about 810 °C to about 890 °C, for about 2 hours to about 20 hours or about 4 hours to about 12 hours. Through the heat treatment, lithium nickel-manganese-based composite oxide may be obtained. The obtained lithium nickel-manganese-based composite oxide may include nickel in an amount of about 60 mol% or more, for example, about 60 mol% to about 80 mol%, based on about 100 mol% of total metals in the obtained lithium nickel-manganese-based composite oxide but include no cobalt or include it in a very small amount of about 0.01 mol% or less. In one or more embodiments, the method may further include pulverization in order to obtain the lithium nickel-manganese-based composite oxide in the form of single particles.

In one or more embodiments, in the preparation of the second positive electrode active material, after obtaining the single particles containing the lithium nickel-manganese-based composite oxide by mixing and heat-treating the nickel-manganese-based composite hydroxide and the lithium raw material, a coating process of the single particles may be further included. The coating the second positive electrode active material in the form of single particles with aluminium may not be achieved by a conventional coating method in the art, but instead the wet coating method according to one or more embodiments of the present disclosure may be applied to form (or provide) a satisfactory coating layer as a substantially uniform film. For example, after mixing an aluminium raw material to an aqueous solvent, the lithium nickel-manganese-based composite oxide in the form of the single particles are added thereto and then, mixing, drying, and heat-treating again to prepare the second positive electrode active material.

Details about the aqueous solvent and aluminium raw material may each independently be the same as described above. An aluminium content (e.g., amount) in the aluminium raw material may be designed to bein a range of about 0.1 mol% to about 2 mol%, for example, about 0.2 mol% to about 1.9 mol%, about 0.3 mol% to about 1.8 mol%, about 0.5 mol% to about 1.5 mol%, or about 0.8 mol% to about 1.3 mol%, based on 100 mol% of a total metal excluding lithium in the second positive electrode active material.

When the aluminium raw material is added to the aqueous solvent, an yttrium raw material also may be added together to coat Al and Y. The yttrium raw material may be, for example, yttrium nitrate, yttrium sulfate, yttrium carbonate, yttrium hydroxide, and/or a (e.g., any suitable) combination thereof. In the yttrium raw material, an yttrium content (e.g., amount) may be designed to be about 0.1 mol% to about 1 mol%, for example, about 0.1 mol% to about 0.9 mol%, about 0.1 mol% to about 0.8 mol%, about 0.1 mol% to about 0.6 mol%, about 0.1 mol% to about 0.4 mol%, or about 0.1 mol% to about 0.3 mol%, based on about 100 mol% of total metals excluding lithium in the second positive electrode active material. If the contents of the coating raw materials are designed to have the ranges, the coating layer may be formed to have a thin and substantially uniform thickness of tens or hundreds of nanometers, which may reduce an amount of generated gas of a rechargeable lithium battery under high voltage conditions and improve high-capacity and long cycle-life characteristics.

The solution obtained by mixing the aluminium raw material and optionally the yttrium raw material in an aqueous solvent may have a pH of about 1.5 to about 3.5, for example, about 2.0 to about 3.4, about 2.5 to about 3.3, about 2.7 to about 3.3, or about 2.9 to about 3.2. Dropping and mixing the lithium nickel-manganese-based composite oxide into an aqueous solvent mixed with the aluminium raw material and yttrium raw material may be carried out for about 5 minutes to about 80 minutes, about 5 minutes to about 60 minutes, or about 5 minutes to about 40 minutes. After the stirring, the mixed solution may have a pH of about 4.5 to about 8.5, for example, about 5.0 to about 8.0, about 5.5 to about 7.5, or about 6.0 to about 7.0. When these conditions are satisfied, it is advantageous to form (or provide) a coating layer with a substantially uniform thickness.

Drying after the mixing process may be understood as a process of removing the solvent and may be carried out, for example, at about 40 °C to about 240 °C, about 100 °C to about 220 °C, or about 150 °C to about 200 °C. The reheat treatment may be understood as a process of forming (or providing) a coating layer on the surface of lithium nickel-manganese-based oxide particles, for example, in an oxygen atmosphere in a temperature range of about 700 °C to about 850 °C, about 750 °C to about 840 °C, or about 800 °C to about 830 °C, for about 2 to about 20 hours, or about 3 to about 10 hours. In one or more embodiments, the reheat treatment temperature may be lower than the former/previous heat treatment temperature, and the reheat treatment time may be the same as or shorter than the former/previous heat treatment time. Under these conditions, the reheat treatment may be performed to obtain a desired or suitable coating layer.

The mixing of the first positive electrode active material, the second positive electrode active material, and the third positive electrode active material may utilize about 60 wt% to about 90 wt% of the first positive electrode active material, about 5 wt% to about 35 wt% of the second positive electrode active material, and about 5 wt% to about 35 wt% of the third positive electrode active material, based on about 100 wt% of a total amount thereof. Non-limiting examples thereof may include about 60 wt% to about 85 wt% of the first positive electrode active material, about 10 wt% to about 25 wt% of the second positive electrode active material, and about 5 wt% to about 20 wt% of the third positive electrode active material. When each of the positive electrode active materials is mixed according to the ratios, capacity may be increased, but also energy density may be maximized or increased.

### Positive Electrode

In one or more embodiments, a positive electrode includes a positive electrode current collector and a positive electrode active material layer on the positive electrode current collector, wherein the positive electrode active material layer includes the aforementioned positive electrode active material. In some embodiments, the positive electrode active material layer may further include other types (kinds) of positive electrode active materials in addition to the positive electrode active materials described above. In one or more embodiments, the positive electrode active material layer may optionally further include a binder, a conductive material, and/or a (e.g., any suitable) combination thereof.

According to one or more embodiments, a loading level of the positive electrode active material layer may be about 10 mg/cm² to about 40 mg/cm², for example, about 10 mg/cm² to about 30 mg/cm², or about 10 mg/cm² to about 20 mg/cm². In one or more embodiments, a density of the positive electrode active material layer in the final compressed positive electrode (e.g., the positive electrode) may be about 3.5 g/cc to about 3.7 g/cc, for example, about 3.5 g/cc to about 3.6 g/cc, or about 3.5 g/cc to about 3.58 g/cc. When applying the positive electrode active material according to one or more embodiments, it is advantageous to implement such a loading level and positive electrode density, and a positive electrode that satisfies the loading level and positive electrode density in the above ranges is suitable for implementing a high-capacity, high-energy-density rechargeable lithium battery.

### Binder

The binder improves binding properties of positive electrode active material particles with one another and with the positive electrode current collector. Examples of binders may include polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinylpyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but embodiments of the present disclosure are not limited thereto.

### Conductive Material

The conductive material (e.g., electron conductor) may be included to provide electrode conductivity, and any electrically conductive material may be utilized as a conductive material unless it causes a chemical change. Non-limiting examples of the conductive material may include a carbon-based material such as natural graphite, artificial graphite, carbon black, acetylene black, Ketjen black, a carbon fiber, a carbon nanofiber, a carbon nanotube, and/or the like; a metal-based material of a metal powder or a metal fiber including copper, nickel, aluminium, silver, and/or the like; a conductive polymer such as a polyphenylene derivative; and/or a (e.g., any suitable) mixture thereof.

Each content (e.g., amount) of the binder and the conductive material may be about 0.5 wt% to about 5 wt% or about 0.5 wt% to about 3 wt%, based on 100 wt% of the positive electrode active material layer.

The positive electrode current collector may include Al, but embodiments of the present disclosure are not limited thereto.

### Rechargeable Lithium Battery

According to one or more embodiments of the present disclosure, a rechargeable lithium battery includes the aforementioned positive electrode, a negative electrode, and an electrolyte.

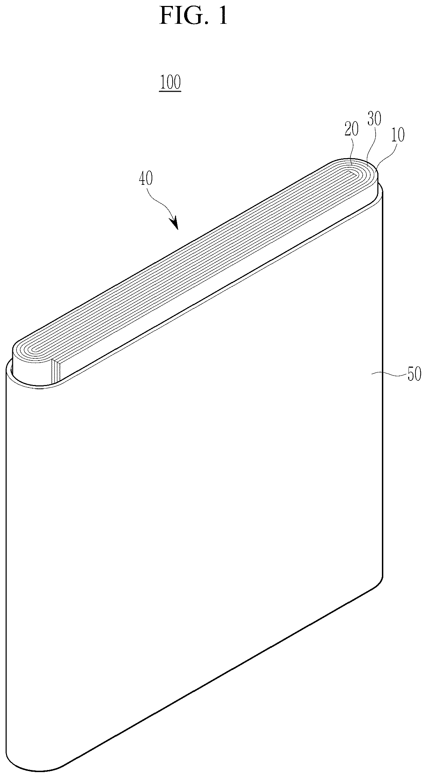

The rechargeable lithium battery may be classified into cylindrical, prismatic, pouch, coin, and/or the like depending on the shape thereof. FIG. 1 is a cross-sectional view schematically showing a rechargeable lithium battery according to one or more embodiments. Referring to FIG. 1, the rechargeable lithium battery 100 may include an electrode assembly 40 with a separator 30 interposed between a positive electrode 10 and a negative electrode 20, and a case 50 in which the electrode assembly 40 is housed. The positive electrode 10, negative electrode 20, and separator 30 may be impregnated with an electrolyte.

The rechargeable lithium battery according to one or more embodiments may be rechargeable at a relatively high voltage, or may be suitable for being driven at a relatively high voltage. For example, in one or more embodiments, the charging voltage of the rechargeable lithium battery may be about 4.3 V to about 4.6 V, or about 4.40 V to about 4.55 V. By applying the positive electrode active material according to one or more embodiments, the rechargeable lithium battery may significantly reduce an amount of gas generated even if (e.g., when) charged at relatively high voltage and may achieve relatively high capacity and long cycle-life characteristics.

### Negative Electrode

The negative electrode may include a negative electrode current collector and a negative electrode active material layer on the negative electrode current collector, and the negative electrode active material layer may include a negative electrode active material, a binder, a conductive material, and/or a (e.g., any suitable) combination thereof.

### Negative Electrode Active Material

The negative electrode active material may include a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may include, for example, crystalline carbon, amorphous carbon, and/or a (e.g., any suitable) combination thereof as a carbon-based negative electrode active material. The crystalline carbon may be irregular, or sheet-shaped, flake-shaped, spherically shaped, or fiber shaped (e.g., in a form of fibers) natural graphite or artificial graphite. The amorphous carbon may be a soft carbon, a hard carbon, a mesophase pitch carbonization product, calcined coke, and/or the like.

The lithium metal alloy includes an alloy of lithium and a metal selected from among sodium (Na), potassium (K), rubidium (Rb), cesium (Cs), francium (Fr), beryllium (Be), magnesium (Mg), calcium (Ca), strontium (Sr), silicon (Si), antimony (Sb), lead (Pb), indium (In), zinc (Zn), barium (Ba), radium (Ra), germanium (Ge), aluminium (Al), and tin (Sn).

The material capable of doping/dedoping lithium may be a Si-based negative electrode active material or a Sn-based negative electrode active material. The Si-based negative electrode active material may include silicon, a silicon-carbon composite, SiOₓ (0 < x ≤ 2), a Si-Q alloy (wherein Q is an element selected from among an alkali metal, an alkaline-earth metal, a Group 13 element, a Group 14 element (excluding Si), a Group 15 element, a Group 16 element, a transition metal, a rare earth element, and/or a (e.g., any suitable) combination thereof, for example, magnesium (Mg), calcium (Ca), strontium (Sr), barium (Ba), radium (Ra), scandium (Sc), yttrium (Y), titanium (Ti), zirconium (Zr), hafnium (Hf), rutherfordium (Rf), vanadium (V), niobium (Nb), tantalum (Ta), dubnium (Db), chromium (Cr), molybdenum (Mo), tungsten (W), seaborgium (Sg), technetium (Tc), rhenium (Re), bohrium (Bh), iron (Fe), lead (Pb), ruthenium (Ru), osmium (Os), hassium (Hs), rhodium (Rh), iridium (Ir), palladium (Pd), platinum (Pt), copper (Cu), silver (Ag), gold (Au), zinc (Zn), cadmium (Cd), boron (B), aluminium (Al), gallium (Ga), tin (Sn), indium (In), thallium (Tl), germanium (Ge), phosphorous (P), arsenic (As), antimony (Sb), bismuth (Bi), sulfur (S), selenium (Se), tellurium (Te), polonium (Po), and/or a (e.g., any suitable) combination thereof), and/or a (e.g., any suitable) combination thereof. The Sn-based negative electrode active material may be Sn, SnOₖ (0 < k ≤ 2) (e.g., SnO₂), a Sn alloy, and/or a (e.g., any suitable) combination thereof.

The silicon-carbon composite may be a composite of silicon and amorphous carbon, in a form of particles. An average particle diameter (D₅₀) of the silicon-carbon composite particles (e.g., secondary particles) may be, for example, about 0.5 micron (µm) to about 20 µm. According to one or more embodiments, the silicon-carbon composite may be in the form of silicon particles and amorphous carbon coated on the surface of each of the silicon particles. For example, in some embodiments, the silicon-carbon composite may include a secondary particle (core) in which silicon primary particles are assembled and an amorphous carbon coating layer (shell) on the surface of the secondary particle. The amorphous carbon may also be present between the silicon primary particles, for example, the silicon primary particles may each be coated with amorphous carbon. The secondary particles may exist dispersed in an amorphous carbon matrix.

The silicon-carbon composite may further include crystalline carbon. For example, in one or more embodiments, the silicon-carbon composite may include a core (e.g., a secondary particle) including crystalline carbon and silicon particles (e.g., primary particles) and an amorphous carbon coating layer on the surface of the core. The crystalline carbon may be artificial graphite, natural graphite, and/or a (e.g., any suitable) combination thereof. The amorphous carbon may include soft carbon or hard carbon, a mesophase pitch carbonized product, or calcined coke.

When the silicon-carbon composite includes silicon and amorphous carbon, a content (e.g., amount) of silicon may be about 10 wt% to about 50 wt% and a content (e.g., amount) of amorphous carbon may be about 50 wt% to about 90 wt%, based on a total weight, 100 wt%, of the silicon-carbon composite. In one or more embodiments, if (e.g., when) the silicon-carbon composite includes silicon, amorphous carbon, and crystalline carbon, a content (e.g., amount) of silicon may be about 10 wt% to about 50 wt%, a content (e.g., amount) of crystalline carbon may be about 10 wt% to about 70 wt%, and a content (e.g., amount) of amorphous carbon may be about 20 wt% to about 40 wt%, based on a total weight, 100 wt%, of the silicon-carbon composite.

In one or more embodiments, a thickness of the amorphous carbon coating layer may be about 5 nm to about 100 nm. An average particle diameter (D₅₀) of the silicon particles (primary particles) may be about 10 nm to about 1 µm, or about 10 nm to about 200 nm. The silicon particles may exist as silicon alone, in the form of a silicon alloy, or in an oxidized form. The oxidized form of silicon may be represented by SiOₓ (0<x≤2). In one or more embodiments, the atomic content (e.g., amount) ratio of Si:O, which indicates a degree of oxidation, may be about 99:1 to about 33:67. As utilized herein, if (e.g., when) a definition is not otherwise provided, an average particle diameter (D50) indicates a particle diameter of a particle where an accumulated volume is about 50 volume% in a particle size distribution.

In one or more embodiments, the Si-based negative electrode active material or Sn-based negative electrode active material may be mixed with the carbon-based negative electrode active material. When the Si-based negative electrode active material or Sn-based negative electrode active material and the carbon-based negative electrode active material are mixed and utilized, the mixing ratio may be a weight ratio of about 1:99 to about 90:10.

### Binder

The binder serves to well adhere the negative electrode active material particles to each other and also to adhere the negative electrode active material to the negative electrode current collector. The binder may be a non-aqueous (e.g., water-insoluble) binder, an aqueous (water-soluble) binder, a dry binder, and/or a (e.g., any suitable) combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, and/or a (e.g., any suitable) combination thereof.

The aqueous binder may include a styrene-butadiene rubber, a (meth)acrylated styrene-butadiene rubber, a (meth)acrylonitrile-butadiene rubber, a (meth)acrylic rubber, butyl rubber, a fluorine rubber, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, and/or a (e.g., any suitable) combination thereof.

If (e.g., when) an aqueous binder is utilized as the binder of the negative electrode, a cellulose-based compound capable of imparting viscosity may be further included. As the cellulose-based compound, one or more of carboxymethyl cellulose, hydroxypropylmethyl cellulose, methyl cellulose, or alkali metal salts thereof may be mixed and utilized. The alkali metal may be Na, K, or Li.

The dry binder may be a polymer material capable of becoming fiber, and may be, for example, polytetrafluoroethylene, polyvinylidene fluoride, a polyvinylidene fluoride-hexafluoropropylene copolymer, polyethylene oxide, and/or a (e.g., any suitable) combination thereof.

### Conductive Material

In one or more embodiments, the conductive material (e.g., electron conductor) may be included to provide and/or improve electrode conductivity, and any electrically conductive material may be utilized as a conductive material unless it causes a chemical change. Non-limiting examples of the conductive material may include a carbon-based material such as natural graphite, artificial graphite, carbon black, acetylene black, Ketjen black, a carbon fiber, a carbon nanofiber, a carbon nanotube, and/or the like; a metal-based material of a metal powder or a metal fiber including copper, nickel, aluminium, silver, and/or the like; a conductive polymer such as a polyphenylene derivative; and/or a (e.g., any suitable) mixture thereof.

A content (e.g., amount) of the negative electrode active material may be about 95 wt% to about 99.5 wt% based on a total weight, 100 wt%, of the negative electrode active material layer, and a content (e.g., amount) of the binder may be about 0.5 wt% to about 5 wt% based on the total weight, 100 wt%, of the negative electrode active material layer. For example, in one or more embodiments, the negative electrode active material layer may include about 90 wt% to about 99 wt% of the negative electrode active material, about 0.5 wt% to about 5 wt% of the binder, and about 0.5 wt% to about 5 wt% of the conductive material, based on the total weight, 100 wt%, of the negative electrode active material layer.

### Negative Electrode Current Collector

The negative electrode current collector may include, for example, indium (In), copper (Cu), magnesium (Mg), stainless steel, titanium (Ti), iron (Fe), cobalt (Co), nickel (Ni), zinc (Zn), aluminium (Al), germanium (Ge), lithium (Li), or an alloy thereof, and may be in the form (or provide) of a foil, a sheet, or a foam. A thickness of the negative electrode current collector may be, for example, about 1 µm to about 20 µm, about 5 µm to about 15 µm, or about 7 µm to about 10 µm.

### Electrolyte

In one or more embodiments, the electrolyte for a rechargeable lithium battery may be an electrolyte, which may include a non-aqueous organic solvent and a lithium salt.

The non-aqueous organic solvent serves as a medium for transmitting ions taking part in the electrochemical reaction of a battery. The non-aqueous organic solvent may be a carbonate-based solvent, an ester-based solvent, an ether-based solvent, a ketone-based solvent, an alcohol-based solvent, an aprotic solvent, and/or a (e.g., any suitable) combination thereof.

The carbonate-based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and/or the like. The ester-based solvent may include methyl acetate, ethyl acetate, n-propyl acetate, dimethyl acetate, methyl propionate, ethyl propionate, decanolide, mevalonolactone, valerolactone, caprolactone, and/or the like. The ether-based solvent may include dibutyl ether, tetraglyme, diglyme, dimethoxyethane, 2-methyltetrahydrofuran, 2,5-dimethyltetrahydrofuran, tetrahydrofuran, and/or the like. In one or more embodiments, the ketone-based solvent may include cyclohexanone, and/or the like. The alcohol-based solvent may include ethanol, isopropyl alcohol, and/or the like, and the aprotic solvent may include nitriles such as R-CN (wherein R is a C2 to C20 linear, branched, or cyclic hydrocarbon group, and may include a double bond, an aromatic ring, or an ether bond, and/or the like); amides such as dimethylformamide; dioxolanes such as 1,3-dioxolane, 1,4-dioxolane, and/or the like; sulfolanes, and/or the like.

The non-aqueous organic solvent may be utilized alone or in a mixture of two or more types (kinds), and if (e.g., when) two or more types (kinds) are utilized in a mixture, a mixing ratio may be appropriately or suitably adjusted according to the desired or suitable battery performance, which is widely suitable to those working in the field.

If (e.g., when) utilizing a carbonate-based solvent, a cyclic carbonate and a chain carbonate may be mixed and utilized, and the cyclic carbonate and the chain carbonate may be mixed in a volume ratio of about 1:1 to about 1:9.

In one or more embodiments, the non-aqueous organic solvent may further include an aromatic hydrocarbon-based organic solvent. For example, in some embodiments, a carbonate-based solvent and an aromatic hydrocarbon-based organic solvent may be mixed and utilized in a volume ratio of about 1:1 to about 30:1.

In one or more embodiments, the electrolyte may further include vinylethylene carbonate, vinylene carbonate, or an ethylene carbonate-based compound to improve battery cycle-life.

Non-limiting examples of the ethylene carbonate-based compound may include fluoroethylene carbonate, difluoroethylene carbonate, chloroethylene carbonate, dichloroethylene carbonate, bromoethylene carbonate, dibromoethylene carbonate, nitroethylene carbonate, and cyanoethylene carbonate.

The lithium salt dissolved in the organic solvent supplies lithium ions in a rechargeable lithium battery, enables a basic operation of the rechargeable lithium battery, and improves transportation of the lithium ions between positive and negative electrodes. Non-limiting examples of the lithium salt may include at least one selected from among LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide; LiFSI), LiC₄F₉SO₃, LiN(CₓF₂ₓ₊₁SO₂)(C_{y}F_{2y+1}SO₂), (wherein x and y are integers of 1 to 20), lithium trifluoromethane sulfonate, lithium tetrafluoroethanesulfonate, lithium difluorobis(oxalato)phosphate (LiDFBOP), and lithium bis(oxalato) borate (LiBOB).

A concentration of lithium salt may be within the range of about 0.1 M to about 2.0 M. When the concentration of lithium salt is within the above range, the electrolyte has appropriate or suitable ionic conductivity and viscosity, and thus excellent or suitable performance may be achieved and lithium ions may move effectively.

### Separator

Depending on the type or kind of the rechargeable lithium battery, a separator may be present between the positive electrode and the negative electrode. The separator may include polyethylene, polypropylene, polyvinylidene fluoride, or a multilayer film of two or more layers thereof, or a mixed multilayer film such as a polyethylene/polypropylene two-layer separator, polyethylene/polypropylene/polyethylene three-layer separator, polypropylene/polyethylene/polypropylene three-layer separator, and/or the like.

The separator may include a porous substrate and a coating layer including an organic material, an inorganic material, and/or a (e.g., any suitable) combination thereof on one or both (e.g., simultaneously) surfaces (e.g., opposite surfaces) of the porous substrate.

The porous substrate may be a polymer film formed of any one selected from among polymer polyolefin such as polyethylene and/or polypropylene, polyester such as polyethylene terephthalate and/or polybutylene terephthalate, polyacetal, polyamide, polyimide, polycarbonate, polyether ketone, polyarylether ketone, polyether ketone, polyetherimide, polyamideimide, polybenzimidazole, polyethersulfone, polyphenylene oxide, a cyclic olefin copolymer, polyphenylene sulfide, polyethylene naphthalate, a glass fiber, and polytetrafluoroethylene (e.g., TEFLON), or a copolymer or a mixture of two or more thereof.

The porous substrate may have a thickness of about 1 µm to about 40 µm, for example, about 1 µm to about 30 µm, about 1 µm to about 20 µm, about 5 µm to about 15 µm, or about 10 µm to about 15 µm.

The organic material may include a (meth)acryl-based copolymer including a first structural unit derived from (meth)acrylamide, and a second structural unit including at least one of a structural unit derived from (meth)acrylic acid or (meth)acrylate, and/or a structural unit derived from (meth)acrylamidosulfonic acid or a salt thereof.

The inorganic material may include inorganic particles selected from among Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and/or a (e.g., any suitable) combination thereof, but embodiments of the present disclosure are not limited thereto. An average particle diameter (D₅₀) of the inorganic particles may be about 1 nm to about 2000 nm, for example, about 100 nm to about 1000 nm, or about 100 nm to about 700 nm.

The organic material and the inorganic material may be mixed in one coating layer, or a coating layer including an organic material and a coating layer including an inorganic material may be stacked.

A thickness of the coating layer may be about 0.5 µm to about 20 µm, for example, about 1 µm to about 10 µm, or about 1 µm to about 5 µm.

Examples and comparative examples of the present disclosure are described in more detail herein. However, the following examples are only examples of the present disclosure, and the present disclosure is not limited to the following examples.

### Example 1

### 1. Preparation of Positive Electrode Active Material

### (1) Preparation of First Positive Electrode Active Material

Ni_{0.75}Mn_{0.23}Al_{0.02}(OH)₂ and LiOH were mixed in a mole ratio of 1:1.05 and then, primarily heat-treated at 850 °C under an oxygen atmosphere for 8 hours to prepare a first composite oxide in the form of secondary particles having a composition of Li_{1.05}Ni_{0.75}Mn_{0.23}Al_{0.02}O₂ and an average particle diameter (D₅₀) of about 14 µm.

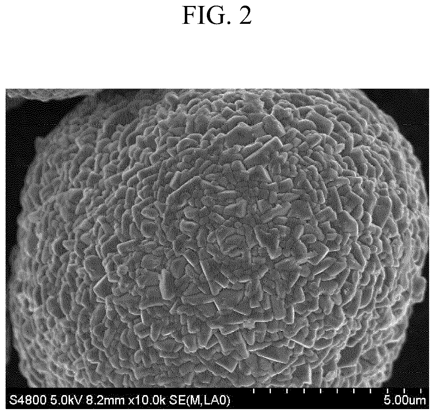

After adding aluminium sulfate to a distilled water solvent, the first composite oxide was added thereto and then, mixed for 20 minutes to 60 minutes. Herein, an aluminium content (e.g., amount) in the aluminium sulfate was designed to be 1.0 mol% based on 100 mol% of total metals excluding lithium in the final first positive electrode active material. After removing the solvent from the mixed solution and drying at 190 °C, zirconium oxide was added thereto and then, secondarily heat-treated at 825 °C for 8 hours under an oxygen atmosphere to obtain the first positive electrode active material. In the zirconium oxide, a zirconium content (e.g., amount) was designed to be 0.2 mol% based on 100 mol% of the total metals excluding lithium in the final first positive electrode active material. FIG. 2 shows an SEM image of the first positive electrode active material. The secondary particles of the first positive electrode active material had an average particle diameter (D₅₀) of about 14 µm.

### (2) Preparation of Second Positive Electrode Active Material

Ni_{0.75}Mn_{0.25}(OH)₂, LiOH, and Al₂O₃ were mixed in a mole ratio of 1:1:0.02 and then, heat-treated at 850 °C for 8 hours under an oxygen atmosphere to prepare a second composite oxide in the form of single particles having a composition of LiNi_{0.75}Mn_{0.23}Al_{0.02}O₂ and an average particle diameter (D₅₀) of about 3 µm.

After mixing aluminium sulfate and yttrium nitrate with a distilled water solvent, the second composite oxide was added thereto and then, mixed for 20 minutes to 60 minutes. Herein, an aluminium content (e.g., amount) in the aluminium sulfate was designed to be 0.4 mol% based on 100 wt% of total metals excluding lithium in the final second positive electrode active material, and an yttrium content

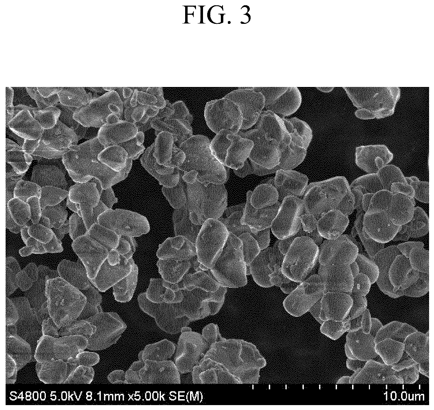

(e.g., amount) in the yttrium nitrate was designed to be 0.1 mol% based on 100 wt% of the total metals excluding lithium in the final second positive electrode active material. After removing the solvent from this mixed solution and drying at 190 °C, a heat treatment at 825 °C for 8 hours under an oxygen atmosphere was performed to prepare the second positive electrode active material. FIG. 3 shows an SEM image of the second positive electrode active material. The single particles of the second positive electrode active material had an average particle diameter (D₅₀) of about 3.5 µm.

### (3) Preparation of Third Positive Electrode Active Material

Mn₃O₄, Li₂CO₃, Al₂O₃, and MgCOs were mixed in a mole ratio of 1:1:0.005:0.005 and then, heat-treated at 700 °C for 8 hours under an oxygen atmosphere to prepare a third composite oxide in the form of single particles having a composition of LiMn_{1.99}Mg_{0.005}Al_{0.005}O₄ and an average particle diameter (D₅₀) of about 7.5 µm. The third composite oxide and Al₂O₃ were mixed so that Al was 0.1 mol% relative to the total Al in Al₂O₃ and all metals excluding lithium in the third composite oxide, and heat-treated at 650°C for 6 hours under oxygen atmosphere to prepare a third positive electrode active material.

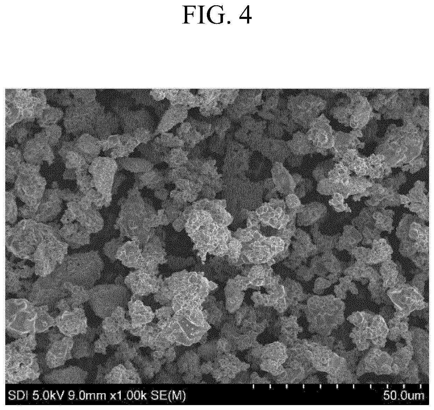

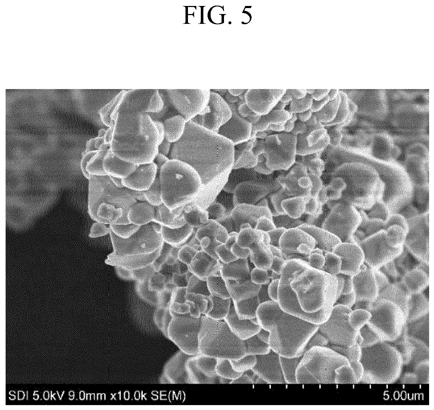

FIG. 4 and FIG. 5 show each an SEM image of the third positive electrode active material.

### (4) Preparation of Final Positive Electrode Active Material

70 wt% of the first positive electrode active material, 20 wt% of the second positive electrode active material, and 10 wt% of the third positive electrode active material were mixed to prepare a final positive electrode active material.

### 2. Manufacture of Positive Electrode

98.5 wt% of the positive electrode active material, 1.0 wt% of a polyvinylidene fluoride binder, and 0.5 wt% of a carbon nanotube conductive material were mixed to prepare a positive electrode active material layer slurry, and the positive electrode active material layer slurry was coated on an aluminium foil current collector and then, dried and compressed to manufacture a positive electrode. A density of the final compressed positive electrode was about 3.52 g/cc.

### 3. Manufacture of Rechargeable Lithium Battery Cell

97.5 wt% of a graphite negative electrode active material, 1.5 wt% of carboxymethyl cellulose, and 1 wt% of a styrene butadiene rubber in a water solvent were mixed to prepare a negative electrode active material layer slurry. The negative electrode active material layer slurry was coated on a copper foil current collector, and then dried and compressed to manufacture a negative electrode.

A polytetrafluoroethylene separator was utilized, and an electrolyte prepared by dissolving 1 M LiPF₆ in a mixed solvent of ethylene carbonate and dimethyl carbonate in a volume ratio of 3:7 was utilized to manufacture a rechargeable lithium battery cell (coin cell) in a common method.

### Example 2

A positive electrode and a rechargeable lithium battery cell were manufactured substantially in substantially the same manner as in Example 1 except that the positive electrode active material was prepared by mixing 70 wt% of the first positive electrode active material, 15 wt% of the second positive electrode active material, and 15 wt% of the third positive electrode active material.

### Comparative Example 1

A positive electrode and a rechargeable lithium battery cell were manufactured substantially in substantially the same manner as in Example 1 except that the positive electrode active material was prepared by mixing 70 wt% of the first positive electrode active material and 30 wt% of the second positive electrode active material without the third positive electrode active material.

### Comparative Example 2

A positive electrode and a rechargeable lithium battery cell were manufactured substantially in substantially the same manner as in Example 1 except that the positive electrode active material was prepared by mixing 70 wt% of the first positive electrode active material and 30 wt% of the third positive electrode active material without the second positive electrode active material.

For better understanding, the design details of the positive electrode active materials of the examples and the comparative examples are briefly shown in Table 1.

**Table 1**

| | First positive electrode active material | | | Second positive electrode active material | | | | Third positive electrode active material | | | | 4.45 V cycl e-life (%, @50 cy) | Av er ag e vol tag e (V) | Positi ve electr ode densi ty (g/cc) |
|---|---|---|---|---|---|---|---|---|---|---|---|---|---|---|
| | Al coati ng (mol %) | Zr coa ting (mo l%) | wt % | Al dop ing (mo l%) | Al coa ting (mo l%) | Y coa ting (mo l%) | wt % | Al dop ing (mo l%) | Mg dopi ng (mol %) | Al coati ng (mol %) | wt % | | | |
| Ex. 1 | 1.0 (wet ) | 0.2 | 70 | 2.0 | 0.4 | 0.1 | 20 | 0.5 | 0.5 | 0.1 | 10 | 98.3 | 3.8 3 | 3.56 |
| Ex. 2 | 1.0 (wet ) | 0.2 | 70 | 2.0 | 0.4 | 0.1 | 15 | 0.5 | 0.5 | 0.1 | 15 | 98.5 | 3.8 5 | 3.53 |
| Comp . Ex. 1 | 1.0 (wet ) | 0.2 | 70 | 2.0 | 0.4 | 0.1 | 30 | - | - | - | 0 | 97.3 | 3.8 0 | 3.52 |
| Comp . Ex. 2 | 1.0 (wet ) | 0.2 | 70 | - | - | - | 0 | 0.5 | 0.5 | 0.1 | 30 | 99.0 | 3.8 7 | 3.35 |

### Evaluation Example 1

Each of the rechargeable lithium battery cells of the examples and the comparative examples was charged at a constant current of 0.2 C to an upper limit voltage of 4.45 V and at a constant voltage to 0.05 C and then, discharged at 0.2 C to a cut-off voltage of 3.0 V at 25 °C for initial charge and discharge. Subsequently, each of the cells was 50 times or more charged at 1.0 C within a voltage range of 3.0 V to 4.45 V and discharged at 1.0 C at 45 °C to calculate a ratio of 50^{th} cycle discharge capacity to initial discharge capacity, and the results are shown in Table 1.

In addition, an average voltage at SOC (State of Charge) 50% during the initial discharge was measured, and the results are shown in Table 1.

In addition, positive electrode density in a pressed state of the examples and the comparative examples is shown in Table 1.

Referring to Table 1, the examples each exhibited much higher positive electrode density and much higher average voltage than the comparative examples and thus result in desirable (e.g., more excellent or suitable) cycle-life characteristics during the driving at a high voltage of 4.45 V.

In present disclosure, "not include a or any 'component'" "exclude a or any 'component'", "'component'-free", and/or the like refers to that the "component" not being added, selected or utilized as a component in the composition/element/structure, but, in some embodiments, the "component" of less than a suitable amount may still be included due to other impurities and/or external factors.

As used herein, the terms "substantially," "about," and similar terms are used as terms of approximation and not as terms of degree, and are intended to account for the inherent deviations in measured or calculated values that would be recognized by those of ordinary skill in the art. "About" or "approximately," as used herein, is also inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

A battery management system (BMS) device, and/or any other relevant devices or components according to embodiments of the present invention described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

While the present disclosure has been described in connection with what is presently considered to be practical example embodiments, it is to be understood that present disclosure is not limited to the disclosed embodiments. In contrast, it is intended to cover one or more suitable modifications and equivalent arrangements included within the scope of the appended claims and equivalents thereof.

Embodiments are set out in the following clauses:
Clause 1. A positive electrode active material, comprising
   a first positive electrode active material comprising a lithium nickel-manganese-based composite oxide having a nickel content of greater than or equal to about 60 mol% based on 100 mol% of a total metal excluding lithium in the first positive electrode active material and being in a form of a plurality of secondary particles each comprising a plurality of primary particles that are agglomerated,
   a second positive electrode active material in a form of a plurality of single particles comprising a lithium nickel-manganese-based composite oxide having a nickel content of greater than or equal to about 60 mol% based on 100 mol% of a total metal excluding lithium in the second positive electrode active material, and
   a third positive electrode active material in a form of a plurality of particles comprising lithium manganese-based oxide.
Clause 2. The positive electrode active material of clause 1, wherein,
   an average particle diameter (D₅₀) of the secondary particles of the first positive electrode active material is about 10 µm to about 20 µm,
   an average particle diameter (D₅₀) of the single particles of the second positive electrode active material is about 0.5 µm to about 8 µm, and
   an average particle diameter (D₅₀) of the particles of the third positive electrode active material is about 5 µm to about 12 µm.
Clause 3. The positive electrode active material of clause 1 or clause 2, wherein,
   based on a total weight, of 100 wt%, of the first positive electrode active material, the second positive electrode active material, and the third positive electrode active material,
   the first positive electrode active material is in an amount of about 60 wt% to about 90 wt%,
   the second positive electrode active material is in an amount of about 5 wt% to about 35 wt%, and
   the third positive electrode active material is in an amount of about 5 wt% to about 35 wt%.
Clause 4. The positive electrode active material of clause 1 or clause 2, wherein,
   based on a total weight, of 100 wt%, of the first positive electrode active material, the second positive electrode active material, and the third positive electrode active material,
   the first positive electrode active material is in an amount of about 60 wt% to about 85 wt%,
   the second positive electrode active material is in an amount of about 10 wt% to about 25 wt%, and
   the third positive electrode active material is in an amount of about 5 wt% to about 20 wt%.
Clause 5. The positive electrode active material of any one of clauses 1 to 4, wherein,
   the lithium nickel-manganese-based composite oxide of the first positive electrode active material and the lithium nickel-manganese-based composite oxide of the second positive electrode active material are the same or different, and each independently has a nickel content of about 60 mol% to about 80 mol% based on 100 mol% of a total metal excluding lithium in each respective lithium nickel-manganese-based composite oxide.
Clause 6. The positive electrode active material of any one of clauses 1 to 5, wherein,
   the lithium nickel-manganese-based composite oxide of the first positive electrode active material and the lithium nickel-manganese-based composite oxide of the second positive electrode active material each independently further comprise aluminium in addition to nickel and manganese, and
   an aluminium content in each respective lithium nickel-manganese-aluminium-based composite oxide is about 1 mol% to about 3 mol% based on 100 mol% of a total metal excluding lithium in each respective lithium nickel-manganese-aluminium-based composite oxide.
Clause 7. The positive electrode active material of any one of clauses 1 to 6, wherein,
   the lithium nickel-manganese-based composite oxide of the first positive electrode active material and the lithium nickel-manganese-based composite oxide of the second positive electrode active material each independently have a cobalt content of about 0 mol% to about 0.01 mol% based on 100 mol% of a total metal excluding lithium in each respective lithium nickel-manganese-based composite oxide, and
   the lithium manganese-based oxide of the third positive electrode active material has a cobalt content of about 0 mol% to about 0.01 mol% based on 100 mol% of a total metal excluding lithium in the lithium manganese-based composite oxide.
Clause 8. The positive electrode active material of any one of clauses 1 to 7, wherein,
the lithium nickel-manganese-based composite oxide of the first positive electrode active material and the lithium nickel-manganese-based composite oxide of the second positive electrode active material are each independently represented by Chemical Formula 1:

   Chemical Formula 1 Liₐ₁Niₓ₁Mn_{y1}Al_{z1}M¹_{w1}O_{2-b1}X_{b1},

   in Chemical Formula 1,
   0.9≤a1≤1.8, 0.6≤x1≤0.8, 0.1≤y1≤0.4, 0≤z1≤0.03, 0≤w1≤0.3, 0.9≤ x1+y1+z1+w1≤1.1, and 0≤b1≤0.1,
   M¹ being one or more elements selected from among B, Ba, Ca, Ce, Cr, Fe, Mg, Mo, Nb, Si, Sn, Sr, Ti, V, W, Y, and Zr, and
   X being one or more elements selected from among F, P, and S.
Clause 9. The positive electrode active material of clause 8, wherein, in Chemical Formula 1, 0.6≤x1≤0.8, 0.1≤y1≤0.39, 0.01≤z1≤0.03, and 0≤w1≤ 0.29 are satisfied.
Clause 10. The positive electrode active material of any one of clauses 1 to 9, wherein,
   the first positive electrode active material further comprises a coating layer on a surface of each of the secondary particles and comprising aluminium.
Clause 11. The positive electrode active material of clause 10, wherein,
   an aluminium content of the coating layer is about 0.1 mol% to about 2 mol% based on 100 mol% of a total metal excluding lithium in the first positive electrode active material.
Clause 12. The positive electrode active material of clause 10 or clause 11, wherein,
   the coating layer further comprise zirconium, yttrium, or a combination thereof.
Clause 13. The positive electrode active material of clause 12, wherein, based on 100 mol% of a total metal excluding lithium in the first positive electrode active material,
   the coating layer comprises:
   about 0.05 mol% to about 1 mol% of zirconium; and/or
   about 0.05 mol% to about 1 mol% of yttrium.
Clause 14. The positive electrode active material of any one of clauses 10 to 13, wherein,
   the coating layer of the first positive electrode active material has a form of a shell that continuously surrounds the surface of each of the secondary particles.
Clause 15. The positive electrode active material of any one of clauses 10 to 14, wherein,
   the coating layer of the first positive electrode active material has a thickness of about 30 nm to about 500 nm.
Clause 16. The positive electrode active material of any one of clauses 10 to 15, wherein,
   the first positive electrode active material further comprises a grain boundary coating portion on a surface of each of the primary particles inside each of the secondary particles and comprising aluminium.
Clause 17. The positive electrode active material of any one of clauses 1 to 16, wherein,
   the second positive electrode active material further comprises a coating layer on a surface of each of the single particles and comprising aluminium.
Clause 18. The positive electrode active material of clause 17, wherein,
   an aluminium content of the coating layer is about 0.1 mol% to about 2 mol% based on 100 mol% of a total metal excluding lithium in the second positive electrode active material.
Clause 19. The positive electrode active material of clause 17 or clause 18, wherein,
   the coating layer of the second positive electrode active material has a form of a shell that continuously surrounds the surface of the single particle.
Clause 20. The positive electrode active material of any one of clauses 17 to 19, wherein,
   a thickness of the coating layer of the second positive electrode active material is about 30 nm to about 500 nm.
Clause 21. The positive electrode active material of any one of clauses 17 to 20, wherein,
   the coating layer of the second positive electrode active material further comprises yttrium.
Clause 22. The positive electrode active material of clause 21, wherein,
   an yttrium content of the coating layer is about 0.1 mol% to about 1 mol% based on 100 mol% of a total metal excluding lithium in the second positive electrode active material.
Clause 23. The positive electrode active material of clause 21 or clause 22, wherein,
   the aluminium exists in the form of a continuous film and the yttrium exists in the form of islands in the coating layer of the second positive electrode active material.
Clause 24. The positive electrode active material of any one of clauses 21 to 23, wherein,
   the second positive electrode active material comprises a first coating layer on the surface of the single particle and comprising aluminium, and a second coating layer on the first coating layer and comprising yttrium.
Clause 25. The positive electrode active material of any one of clauses 1 to 24, wherein,
   the third positive electrode active material has a form of a plurality of secondary particles each comprising a plurality of primary particles that are agglomerated.
Clause 26. The positive electrode active material of any one of clauses 1 to 25, wherein,
   the lithium manganese-based oxide of the third positive electrode active material further comprises aluminium, magnesium, yttrium, or a combination thereof, in addition to manganese.
Clause 27. The positive electrode active material of any one of clauses 1 to 26, wherein,
   the lithium manganese-based oxide of the third positive electrode active material is represented by Chemical Formula 3:

      Chemical Formula 3 Liₐ₃Mnₓ₃M³_{y3}O_{4-b3}X_{b3},

      in Chemical Formula 3,
   0.9≤a3≤1.8, 1.7≤x3≤2, 0≤y3≤0.3, 1.9≤x3+y3≤2.1, and 0≤b3≤0.1,
   M³ being one or more elements selected from among Al, B, Ba, Ca, Ce, Cr, Fe, Mg, Mo, Nb, Si, Sn, Sr, Ti, V, W, Y, and Zr, and
   X being one or more elements selected from among F, P, and S.
Clause 28. The positive electrode active material of clause 27, wherein,
   the lithium manganese-based oxide of the third positive electrode active material is represented by Chemical Formula 4:

      Chemical Formula 4 Liₐ₄Mnₓ₄Al_{y4}Mg_{z4}M⁴_{w4}O_{4-b4}X_{b4},

      in Chemical Formula 4,
   0.9≤a4≤1.8, 1.7≤x4<2.0, 0<y4≤0.015, 0<z4≤0.010, 0≤w4<0.3, 1.9≤ x4+y4+z4+w4≤2.1, and 0≤b4≤0.1,
   M⁴ being one or more elements selected from among B, Ba, Ca, Ce, Cr, Fe, Mo, Nb, Si, Sn, Sr, Ti, V, W, Y, and Zr, and
   X being one or more elements selected from among F, P, and S.
Clause 29. The positive electrode active material of any one of clauses 1 to 28, wherein,
   the third positive electrode active material further comprises a coating layer on a surface of each of the particles and comprising aluminium.
Clause 30. The positive electrode active material of clause 29, wherein,
   the aluminium in the coating layer is in an amount of about 0.01 mol% to about 1 mol% based on 100 mol% of a total metal excluding lithium in the third positive electrode active material.
Clause 31. A positive electrode, comprising
   a positive electrode current collector, and
   a positive electrode active material layer on the positive electrode current collector, the positive electrode active material layer comprising the positive electrode active material of any one of clauses 1 to 30.
Clause 32. The positive electrode of clause 31, wherein,
   the positive electrode active material layer has a density of about 3.5 g/cc to about 3.7 g/cc.
Clause 33. A rechargeable lithium battery, comprising
   the positive electrode of clause 31 or clause 32,
   a negative electrode, and
   an electrolyte.
Clause 34. The rechargeable lithium battery of clause 33, wherein a charge voltage of the rechargeable lithium battery is about 4.3 V to about 4.6 V.

### Reference Numerals

| | | | |
|---|---|---|---|
| 100: | rechargeable lithium battery | 10: | positive electrode |
| 20: | negative electrode | 30: | separator |
| 40: | electrode assembly | 50: | case |

## Claims

1. A positive electrode active material, comprising
a first positive electrode active material comprising a lithium nickel-manganese-based composite oxide having a nickel content of greater than or equal to about 60 mol% based on 100 mol% of a total metal excluding lithium in the first positive electrode active material and being in a form of a plurality of secondary particles each comprising a plurality of primary particles that are agglomerated,
a second positive electrode active material in a form of a plurality of single particles comprising a lithium nickel-manganese-based composite oxide having a nickel content of greater than or equal to about 60 mol% based on 100 mol% of a total metal excluding lithium in the second positive electrode active material, and
a third positive electrode active material in a form of a plurality of particles comprising lithium manganese-based oxide.

2. The positive electrode active material as claimed in claim 1, wherein,
an average particle diameter (D₅₀) of the secondary particles of the first positive electrode active material is about 10 µm to about 20 µm,
an average particle diameter (D₅₀) of the single particles of the second positive electrode active material is about 0.5 µm to about 8 µm, and
an average particle diameter (D₅₀) of the particles of the third positive electrode active material is about 5 µm to about 12 µm.

3. The positive electrode active material as claimed in claim 1 or claim 2, wherein:
(i) based on a total weight, of 100 wt%, of the first positive electrode active material, the second positive electrode active material, and the third positive electrode active material,
the first positive electrode active material is in an amount of about 60 wt% to about 90 wt%,
the second positive electrode active material is in an amount of about 5 wt% to about 35 wt%, and
the third positive electrode active material is in an amount of about 5 wt% to about 35 wt%; or
(ii) based on a total weight, of 100 wt%, of the first positive electrode active material, the second positive electrode active material, and the third positive electrode active material,
the first positive electrode active material is in an amount of about 60 wt% to about 85 wt%,
the second positive electrode active material is in an amount of about 10 wt% to about 25 wt%, and
the third positive electrode active material is in an amount of about 5 wt% to about 20 wt%.

4. The positive electrode active material as claimed in any one of claims 1 to 3, wherein:
(i) the lithium nickel-manganese-based composite oxide of the first positive electrode active material and the lithium nickel-manganese-based composite oxide of the second positive electrode active material are the same or different, and each independently has a nickel content of about 60 mol% to about 80 mol% based on 100 mol% of a total metal excluding lithium in each respective lithium nickel-manganese-based composite oxide; and/or
(ii) the lithium nickel-manganese-based composite oxide of the first positive electrode active material and the lithium nickel-manganese-based composite oxide of the second positive electrode active material each independently further comprise aluminium in addition to nickel and manganese, and
an aluminium content in each respective lithium nickel-manganese-aluminium-based composite oxide is about 1 mol% to about 3 mol% based on 100 mol% of a total metal excluding lithium in each respective lithium nickel-manganese-aluminium-based composite oxide; and/or
(iii) the lithium nickel-manganese-based composite oxide of the first positive electrode active material and the lithium nickel-manganese-based composite oxide of the second positive electrode active material each independently have a cobalt content of about 0 mol% to about 0.01 mol% based on 100 mol% of a total metal excluding lithium in each respective lithium nickel-manganese-based composite oxide, and
the lithium manganese-based oxide of the third positive electrode active material has a cobalt content of about 0 mol% to about 0.01 mol% based on 100 mol% of a total metal excluding lithium in the lithium manganese-based composite oxide; and/or
(iv) the lithium nickel-manganese-based composite oxide of the first positive electrode active material and the lithium nickel-manganese-based composite oxide of the second positive electrode active material are each independently represented by Chemical Formula 1:
Chemical Formula 1 Liₐ₁Niₓ₁Mn_{y1}Al_{z1}M¹_{w1}O_{2-b1}X_{b1},
in Chemical Formula 1,
0.9≤a1 ≤ 1.8, 0.6≤x1 ≤0.8, 0.1 ≤y1 ≤0.4, 0≤z1 ≤0.03, 0≤w1 ≤0.3, 0.9≤ x1+y1+z1+w1≤1.1, and 0≤b1≤0.1,
M¹ being one or more elements selected from among B, Ba, Ca, Ce, Cr, Fe, Mg, Mo, Nb, Si, Sn, Sr, Ti, V, W, Y, and Zr, and
X being one or more elements selected from among F, P, and S, optionally wherein,
in Chemical Formula 1, 0.6≤x1 ≤0.8, 0.1 ≤y1 ≤0.39, 0.01 ≤z1 ≤0.03, and 0≤w1 ≤ 0.29 are satisfied.

5. The positive electrode active material as claimed in any one of claims 1 to 4, wherein,
the first positive electrode active material further comprises a coating layer on a surface of each of the secondary particles and comprising aluminium.

6. The positive electrode active material as claimed in claim 5, wherein:
(i) an aluminium content of the coating layer is about 0.1 mol% to about 2 mol% based on 100 mol% of a total metal excluding lithium in the first positive electrode active material; and/or
(ii) the coating layer further comprises zirconium, yttrium, or a combination thereof, optionally wherein, based on 100 mol% of a total metal excluding lithium in the first positive electrode active material,
the coating layer comprises:
about 0.05 mol% to about 1 mol% of zirconium; and/or
about 0.05 mol% to about 1 mol% of yttrium.

7. The positive electrode active material as claimed in claim 5 or claim 6, wherein:
(i) the coating layer of the first positive electrode active material has a form of a shell that continuously surrounds the surface of each of the secondary particles; and/or
(ii) the coating layer of the first positive electrode active material has a thickness of about 30 nm to about 500 nm; and/or
(iii) the first positive electrode active material further comprises a grain boundary coating portion on a surface of each of the primary particles inside each of the secondary particles and comprising aluminium.

8. The positive electrode active material as claimed in any one of claims 1 to 7, wherein,
the second positive electrode active material further comprises a coating layer on a surface of each of the single particles and comprising aluminium.

9. The positive electrode active material as claimed in claim 8, wherein:
(i) an aluminium content of the coating layer is about 0.1 mol% to about 2 mol% based on 100 mol% of a total metal excluding lithium in the second positive electrode active material; and/or
(ii) the coating layer of the second positive electrode active material has a form of a shell that continuously surrounds the surface of the single particle; and/or
(iii) a thickness of the coating layer of the second positive electrode active material is about 30 nm to about 500 nm.

10. The positive electrode active material as claimed in claim 8 or claim 9, wherein,
the coating layer of the second positive electrode active material further comprises yttrium.

11. The positive electrode active material as claimed in claim 10, wherein:
(i) an yttrium content of the coating layer is about 0.1 mol% to about 1 mol% based on 100 mol% of a total metal excluding lithium in the second positive electrode active material; and/or
(ii) the aluminium exists in the form of a continuous film and the yttrium exists in the form of islands in the coating layer of the second positive electrode active material; and/or
(iii) the second positive electrode active material comprises a first coating layer on the surface of the single particle and comprising aluminium, and a second coating layer on the first coating layer and comprising yttrium.

12. The positive electrode active material as claimed in any one of claims 1 to 11, wherein:
(i) the third positive electrode active material has a form of a plurality of secondary particles each comprising a plurality of primary particles that are agglomerated; and/or
(ii) the lithium manganese-based oxide of the third positive electrode active material further comprises aluminium, magnesium, yttrium, or a combination thereof, in addition to manganese; and/or
(iii) the lithium manganese-based oxide of the third positive electrode active material is represented by Chemical Formula 3:
Chemical Formula 3 Liₐ₃Mnₓ₃M³_{y3}O_{4-b3}X_{b3},
in Chemical Formula 3,
0.9≤a3≤ 1.8, 1.7≤x3≤2, 0≤y3≤0.3, 1.9≤x3+y3≤2.1, and 0≤b3≤0.1,
M³ being one or more elements selected from among Al, B, Ba, Ca, Ce, Cr, Fe, Mg, Mo, Nb, Si, Sn, Sr, Ti, V, W, Y, and Zr, and
X being one or more elements selected from among F, P, and S, optionally wherein,
the lithium manganese-based oxide of the third positive electrode active material is represented by Chemical Formula 4:
Chemical Formula 4 Liₐ₄Mnₓ₄Al_{y4}Mg_{z4}M⁴_{w4}O_{4-b4}X_{b4},
in Chemical Formula 4,
0.9≤a4≤ 1.8, 1.7 ≤x4<2.0, 0<y4≤0.015, 0<z4≤0.010, 0≤w4<0.3, 1.9≤ x4+y4+z4+w4≤2.1, and 0≤b4≤0.1,
M⁴ being one or more elements selected from among B, Ba, Ca, Ce, Cr, Fe, Mo, Nb, Si, Sn, Sr, Ti, V, W, Y, and Zr, and
X being one or more elements selected from among F, P, and S.

13. The positive electrode active material as claimed in any one of claims 1 to 12, wherein,
the third positive electrode active material further comprises a coating layer on a surface of each of the particles and comprising aluminium, optionally wherein,
the aluminium in the coating layer is in an amount of about 0.01 mol% to about 1 mol% based on 100 mol% of a total metal excluding lithium in the third positive electrode active material.

14. A positive electrode, comprising
a positive electrode current collector, and
a positive electrode active material layer on the positive electrode current collector, the positive electrode active material layer comprising the positive electrode active material as claimed in any one of claims 1 to 13, optionally wherein,
the positive electrode active material layer has a density of about 3.5 g/cc to about 3.7 g/cc.

15. A rechargeable lithium battery, comprising
the positive electrode as claimed in claim 14,
a negative electrode, and
an electrolyte, optionally wherein a charge voltage of the rechargeable lithium battery is about 4.3 V to about 4.6 V.
